(19) Europäisches Patentamt / European Patent Office / Office européen des brevets

(11) **EP 4 235 769 A1**

(12) # EUROPEAN PATENT APPLICATION
published in accordance with Art. 153(4) EPC

(43) Date of publication:
**30.08.2023 Bulletin 2023/35**

(21) Application number: **21882467.0**

(22) Date of filing: **09.09.2021**

(51) International Patent Classification (IPC):
**H01L 23/02** (2006.01)  **H01L 23/20** (2006.01)
**H01L 27/146** (2006.01)  **H04N 5/369** (2011.01)

(52) Cooperative Patent Classification (CPC):
**H01L 23/02; H01L 23/20; H01L 27/146;
H04N 25/70**

(86) International application number:
**PCT/JP2021/033083**

(87) International publication number:
**WO 2022/085326 (28.04.2022 Gazette 2022/17)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **22.10.2020 JP 2020177339**

(71) Applicant: **Sony Semiconductor Solutions
Corporation
Atsugi-shi, Kanagawa 243-0014 (JP)**

(72) Inventors:
• **CHINO, Daisuke**
  **Atsugi-shi, Kanagawa 243-0014 (JP)**
• **KANATAKE, Mitsuhito**
  **Atsugi-shi, Kanagawa 243-0014 (JP)**
• **MURAYAMA, Toshihiro**
  **Atsugi-shi, Kanagawa 243-0014 (JP)**

(74) Representative: **MFG Patentanwälte
Meyer-Wildhagen Meggle-Freund
Gerhard PartG mbB
Amalienstraße 62
80799 München (DE)**

(54) **IMAGING DEVICE, ELECTRONIC APPARATUS, AND METHOD FOR MANUFACTURING
IMAGING DEVICE**

(57) In a configuration in which a transparent member is mounted on an imaging element with a gap, the imaging element can be downsized, and a package structure can be downsized.

An imaging device includes a substrate, an imaging element mounted on the substrate and having a side opposite to a side of the substrate as a light receiving surface side, a transparent member provided on the light receiving surface side of the imaging element at a predetermined interval with respect to the imaging element, a support portion that is interposed between the imaging element and the transparent member and forms a cavity that is a sealed space between the imaging element and the transparent member, and a connecting member that electrically connects the substrate and the imaging element, in which the support portion includes a solder layer portion formed by solder.

*FIG. 1*

EP 4 235 769 A1

## Description

### TECHNICAL FIELD

The present technology relates to an imaging device, an electronic device, and a manufacturing method of the imaging device.

### BACKGROUND ART

Conventionally, there is an imaging device including an imaging element having the following configuration in order to achieve downsizing of the package, or the like. That is, by mounting a transparent member such as a glass on the imaging element via a support resin portion which is a support portion formed by resin, the transparent member is mounted with a gap from the imaging element (for example, see Patent Document 1 and Patent Document 2).

In the configuration having such what is called GOC (Glass on Chip) structure, a periphery between the imaging element and the transparent member is sealed by the support resin portion provided on a light receiving surface side of the imaging element, and a cavity is formed between the imaging element and the transparent member. Then, incident light on the imaging device passes through the transparent member and passes through the cavity, and is received by a light receiving element constituting each pixel arranged in a pixel unit forming a light receiving region of the imaging element.

Patent Document 1 discloses a configuration in which ultraviolet curable resin is provided as a support resin portion that supports a transparent member on an imaging element, so as to cover an electrode formed on a peripheral edge portion of the imaging element and a connecting portion of a bonding wire to the electrode. Furthermore, Patent Document 2 discloses a configuration in which an adhesive layer to which a filler such as silica is added is provided as a support resin portion that supports a transparent member on an imaging element.

### CITATION LIST

#### PATENT DOCUMENT

Patent Document 1: Japanese Patent Application Laid-Open No. 2002-16194
Patent Document 2: Japanese Patent Application Laid-Open No. 2003-163342

### SUMMARY OF THE INVENTION

### PROBLEMS TO BE SOLVED BY THE INVENTION

As described above, the configuration in which the transparent member is mounted on the imaging element via the support resin portion has the following problems.

The support resin portion is usually formed by applying resin by a dispenser so as to surround the pixel unit on the light receiving surface side of the imaging element. From the viewpoint of not blocking incident light to the pixel unit in the imaging element, application of the resin to the imaging element needs to be performed so that the resin is not applied to the pixel unit. For this reason, it is necessary to apply the resin to a portion at a certain distance from the pixel unit.

Therefore, when providing the support resin portion formed by applying resin, it is necessary to secure a distance between the pixel unit and an electrode pad in the imaging element, resulting in a large imaging element design and a large chip size. Note that a plurality of electrode pads is formed in a predetermined arrangement in a portion outside the support resin portion on the light receiving surface side of the imaging element, and receives connections of one end sides of bonding wires.

Furthermore, in application of the resin by the dispenser, thickening or bleeding of the resin occurs at the starting and ending points, and thus it is necessary to perform designing so that an application region of the resin is secured in the imaging element in consideration of such characteristics of resin. Thus, the chip size increases.

Moreover, in mounting the transparent member, the transparent member is mounted after the resin is applied to the imaging element, and alignment of the transparent member is mechanically performed using image processing or the like. Here, in a case where sufficient mounting accuracy for mounting the transparent member cannot be obtained, it is necessary to secure a certain distance between the pixel unit and the electrode pads in the imaging element in relation to the mounting accuracy. That is, in order to avoid occurrence of positional displacement of the transparent member and interference of the transparent member with the bonding wires connected to the electrode pads, it is necessary to secure a considerable application region of the resin in the imaging element. This also causes an increase in chip size.

In recent years, the distance between the pixel unit and the electrode pads can be shortened by applying a structure or the like in which a logic circuit or the like is stacked under a pixel in an imaging element by a wafer bonding technique or the like. However, in the configuration including the conventional support resin portion as described above, it is necessary to secure the distance between the pixel unit and the electrode pads to some extent, and thus it is difficult to downsize the imaging element.

An object of the present technology is to provide an imaging device, an electronic device, and a manufacturing method of the imaging device capable of downsizing an imaging element and downsizing a package structure in a configuration in which a transparent member is mounted on the imaging element with a gap.

SOLUTIONS TO PROBLEMS

An imaging device according to the present technology includes a substrate, an imaging element mounted on the substrate and having a side opposite to a side of the substrate as a light receiving surface side, a transparent member provided on the light receiving surface side of the imaging element at a predetermined interval with respect to the imaging element, a support portion that is interposed between the imaging element and the transparent member and forms a cavity that is a sealed space between the imaging element and the transparent member, and a connecting member that electrically connects the substrate and the imaging element, in which the support portion includes a solder layer portion formed by solder.

In another aspect of the imaging device according to the present technology, the imaging device further includes a covering resin portion that is provided around the imaging element on the substrate and covers the connecting member and connecting portions of the connecting member with respect to each of the substrate and the imaging element.

In another aspect of the imaging device according to the present technology, in the imaging device, the transparent member has an outer dimension in plan view smaller than the outer dimension of the imaging element, and is provided within a range of an outer shape of the imaging element in plan view.

In another aspect of the imaging device according to the present technology, in the imaging device, the support portion includes a metal layer portion formed by copper or an alloy containing copper on at least one of a side of the imaging element or a side of the transparent member of the solder layer portion.

In another aspect of the imaging device according to the present technology, in the imaging device, the support portion includes a first connection layer portion that is a connecting portion with respect to the imaging element, and a second connection layer portion that is a connecting portion with respect to the transparent member, and an edge end on an inside of the second connection layer portion with respect to the cavity is positioned closer to the inside than an edge end on the inside of the first connection layer portion.

In another aspect of the imaging device according to the present technology, the imaging device further includes a fine wiring portion provided on a surface of the transparent member on a side of the cavity and connected to a GND potential of the imaging element via the support portion.

In another aspect of the imaging device according to the present technology, the imaging device further includes a heat-generating fine wiring portion that is provided on a surface of the transparent member on a side opposite to a side of the cavity, is electrically connected to the support portion, and generates heat by receiving supply of a current from the imaging element.

In another aspect of the imaging device according to the present technology, in the imaging device, nitrogen gas is sealed in the cavity.

In another aspect of the imaging device according to the present technology, in the imaging device, an inside of the cavity is in a vacuum state.

An electronic device according to the present technology includes an imaging device, in which the imaging device includes a substrate, an imaging element mounted on the substrate and having a side opposite to a side of the substrate as a light receiving surface side, a transparent member provided on the light receiving surface side of the imaging element at a predetermined interval with respect to the imaging element, a support portion that is interposed between the imaging element and the transparent member and forms a cavity that is a sealed space between the imaging element and the transparent member, and a connecting member that electrically connects the substrate and the imaging element, and the support portion includes a solder layer portion formed by solder.

A manufacturing method of an imaging device according to the present technology includes the steps of preparing a substrate, preparing an imaging element in which a first connection layer portion is formed on a light receiving surface side as an imaging element to be mounted on the substrate, preparing, as a transparent member to be mounted on the imaging element, a transparent member on which a solder portion is formed via a second connection layer portion having a shape corresponding to the first connection layer portion on one side, mounting the imaging element on the substrate, providing a connecting member that electrically connects the substrate and the imaging element, and placing the transparent member on the imaging element in such a manner that the solder portion is positioned on the first connection layer portion, melting the solder portion, and forming a support portion that is interposed between the imaging element and the transparent member and forms a cavity that is a sealed space between the imaging element and the transparent member.

In another aspect of the manufacturing method of the imaging device according to the present technology, the manufacturing method of the imaging device further includes a step of forming a covering resin portion around the imaging element on the substrate so as to cover the connecting member and connecting portions of the connecting member with respect to each of the substrate and the imaging element after the step of forming the support portion.

In another aspect of the manufacturing method of the imaging device according to the present technology, in the manufacturing method of the imaging device, the step of preparing the transparent member includes a step of forming, on a surface of the transparent member on a side of the cavity, a fine wiring portion connected to a GND potential of the imaging element via the support portion.

In another aspect of the manufacturing method of the imaging device according to the present technology, in the manufacturing method of the imaging device, the step of preparing the transparent member includes a step of forming, on a surface of the transparent member on a side opposite to a side of the cavity, a heat-generating fine wiring portion that is electrically connected to the support portion and generates heat by receiving supply of a current from the imaging element.

In another aspect of the manufacturing method of the imaging device according to the present technology, in the manufacturing method of the imaging device, in the step of forming the support portion, nitrogen gas is sealed in the cavity.

In another aspect of the manufacturing method of the imaging device according to the present technology, in the manufacturing method of the imaging device, in the step of forming the support portion, an inside of the cavity is evacuated.

BRIEF DESCRIPTION OF DRAWINGS

Fig. 1 is a side cross-sectional view illustrating a configuration of an imaging device according to a first embodiment of the present technology.
Fig. 2 is a top view illustrating a configuration of an image sensor according to the first embodiment of the present technology.
Fig. 3 is a bottom view illustrating a configuration of a glass and a solder layer portion according to the first embodiment of the present technology.
Fig. 4 is a side cross-sectional view illustrating a configuration of a substrate according to the first embodiment of the present technology.
Fig. 5 is a side cross-sectional view illustrating a configuration of the image sensor according to the first embodiment of the present technology.
Fig. 6 is a view illustrating a configuration of the glass according to the first embodiment of the present technology. Fig. 6A is a side cross-sectional view illustrating the configuration of the glass according to the first embodiment of the present technology.
Fig. 6B is a bottom view illustrating the configuration of the glass according to the first embodiment of the present technology.
Fig. 7 is a side cross-sectional view illustrating a state in which a solder portion is formed on a glass-side connection layer portion of the glass according to the first embodiment of the present technology.
Fig. 8 is an explanatory view of an assembly step of the imaging device according to the first embodiment of the present technology.
Fig. 9 is a side cross-sectional view illustrating a configuration of Modification 1 of the imaging device according to the first embodiment of the present technology.
Fig. 10 is a side cross-sectional view illustrating a configuration of Modification 2 of the imaging device according to the first embodiment of the present technology.
Fig. 11 is a side cross-sectional view illustrating a configuration of Modification 3 of the imaging device according to the first embodiment of the present technology.
Fig. 12 is a side cross-sectional view illustrating a configuration of a support portion according to a second embodiment of the present technology.
Fig. 13 is a bottom view illustrating a configuration of a glass according to the second embodiment of the present technology.
Fig. 14 is an explanatory view illustrating a configuration of a comparative example with respect to the support portion according to the second embodiment of the present technology.
Fig. 15 is a side cross-sectional view illustrating a configuration of Modification 1 of the support portion according to the second embodiment of the present technology.
Fig. 16 is a side cross-sectional view illustrating a configuration of Modification 2 of the support portion according to the second embodiment of the present technology.
Fig. 17 is a side cross-sectional view illustrating a configuration of an imaging device according to a third embodiment of the present technology.
Fig. 18 is a bottom view illustrating a configuration of a glass according to the third embodiment of the present technology.
Fig. 19 is a side cross-sectional view illustrating a configuration of an imaging device according to a fourth embodiment of the present technology.
Fig. 20 is a top view illustrating a configuration of a glass according to the fourth embodiment of the present technology.
Fig. 21 is a bottom view illustrating a configuration of a glass according to the fourth embodiment of the present technology.
Fig. 22 is a block diagram illustrating a configuration example of an electronic device including the imaging device according to the embodiment of the present technology.

MODE FOR CARRYING OUT THE INVENTION

The present technology relates to a configuration in which a transparent member is mounted on an imaging element with a support portion interposed therebetween via a gap, and attempts to downsize the imaging element and, in turn, downsize the package structure by devising the configuration of the support portion.

Hereinafter, modes for carrying out the present technology (hereinafter referred to as "embodiments") will be described with reference to the drawings. Note that the embodiments will be described in the following order.

1. Configuration example of imaging device according to first embodiment
2. Manufacturing method of imaging device according to first embodiment
3. Modification of imaging device according to first embodiment
4. Configuration example of imaging device according to second embodiment
5. Modification of imaging device according to second embodiment
6. Configuration example of imaging device according to third embodiment
7. Manufacturing method of imaging device according to third embodiment
8. Configuration example of imaging device according to fourth embodiment
9. Manufacturing method of imaging device according to fourth embodiment
10. Configuration example of electronic device

<1. Configuration example of imaging device according to first embodiment>

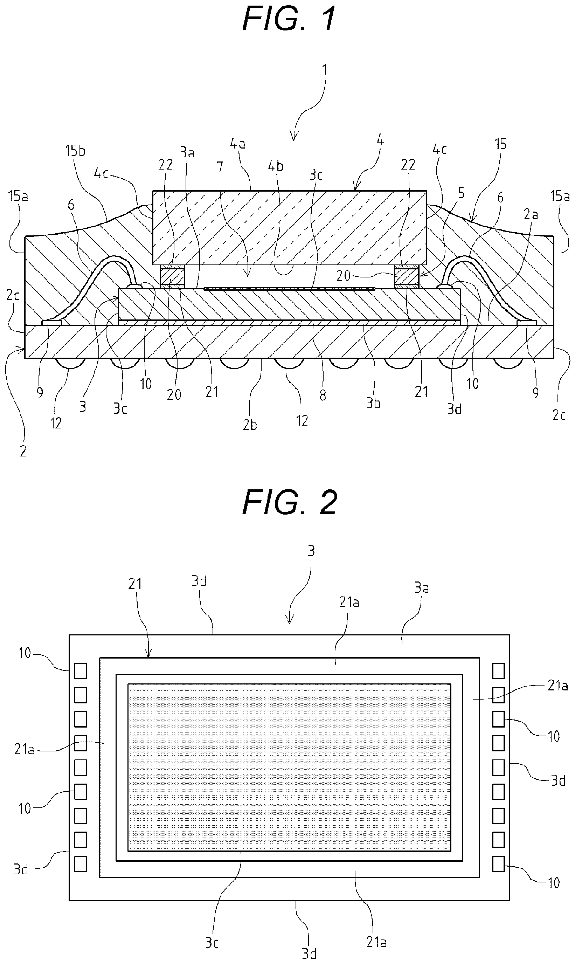

A configuration example of an imaging device according to a first embodiment of the present technology will be described with reference to Figs. 1, 2, and 3. Note that upper and lower sides in Fig. 1 are upper and lower sides in an imaging device 1.

As illustrated in Fig. 1, an imaging device 1 is a type of semiconductor device, and includes a substrate 2, an image sensor 3 as an imaging element, a glass 4 as a transparent member, a support portion 5 interposed between the image sensor 3 and the glass 4 to support the glass 4 on the image sensor 3, and bonding wires 6 as a plurality of connecting members. The imaging device 1 has a package structure in which the glass 4 is mounted on the image sensor 3 via the support portion 5, and a cavity 7 is formed between the image sensor 3 and the glass 4.

In the imaging device 1, the glass 4 is supported by the support portion 5 provided on a front surface 3a, which is a surface on a light receiving side of the image sensor 3, so as to face the front surface 3a with respect to the image sensor 3. A periphery between the image sensor 3 and the glass 4 is sealed by the support portion 5, and the cavity 7 is formed.

The substrate 2 is an organic substrate including an organic material such as plastic, and is a circuit board on which a predetermined circuit is formed. However, the substrate 2 may be another type of substrate such as a ceramic substrate formed using ceramics or the like as a material. The substrate 2 has a front surface 2a on which the image sensor 3 is mounted and a back surface 2b that is a plate surface on the opposite side.

The image sensor 3 is bonded to the front surface 2a side of the substrate 2 by a bonding material 8 which is an insulating or conductive adhesive or the like.

The image sensor 3 is mounted on the substrate 2, and a side opposite to the substrate 2 side is a light receiving surface side. The image sensor 3 is a semiconductor element including a semiconductor substrate including silicon (Si) which is an example of a semiconductor. The image sensor 3 is a rectangular plate-shaped chip, the front surface 3a side which is an upper plate surface is a light receiving surface side, and a plate surface on an opposite side is a back surface 3b. A plurality of light receiving elements (photoelectric conversion elements) is formed on the front surface 3a side of the image sensor 3. The image sensor 3 is a complementary metal oxide semiconductor (CMOS) type image sensor. However, the image sensor 3 may be another imaging element such as a charge coupled device (CCD) type image sensor.

The image sensor 3 includes, on the front surface 3a side, a pixel unit 3c that is a pixel region including a large number of pixels formed in a predetermined array such as a Bayer array as a light receiving unit, for example, and a region around the pixel unit 3c is set as a peripheral region. A predetermined peripheral circuit is formed in the peripheral region. The pixel unit 3c includes an effective pixel region for generating, amplifying, and reading signal charge by photoelectric conversion in each pixel. In the peripheral circuit of the image sensor 3, signal processing such as correlated double sampling (CDS), signal amplification, and analog/digital (A/D) conversion is performed on a pixel signal based on signal charge generated according to the amount of received light in each pixel. The pixel of the pixel unit 3c includes a photodiode as a photoelectric conversion unit having a photoelectric conversion function, and a plurality of pixel transistors.

On the front surface 3a side of the image sensor 3, a color filter and an on-chip lens are formed corresponding to each pixel via an antireflection film, the antireflection film including an oxide film or the like, a planarization film formed by an organic material, or the like, with respect to the semiconductor substrate. The light incident on the on-chip lens is received by the photodiode via a color filter, a planarization film, and the like. Note that the configuration of the image sensor 3 according to the present technology is not particularly limited.

The glass 4 is an example of a transparent member to be an optical window, has a rectangular plate-like outer shape, and is provided on the front surface 3a side of the image sensor 3 at a predetermined interval in parallel with the image sensor 3. The glass 4 has a back surface 4b which is an upper plate surface facing the image sensor 3 and a front surface 4a which is an upper surface opposite to the back surface 4b. The glass 4 is supported in a fixed state by the support portion 5 with respect to the image sensor 3.

The glass 4 transmits various kinds of light incident from an optical system such as a lens positioned above the glass 4. The light transmitted through the glass 4 reaches the light receiving surface of the image sensor 3 via the cavity 7. The glass 4 has a function of protecting the light receiving surface side of the image sensor 3. Note that, as the transparent member according to the present technology, for example, a plastic plate, a silicon plate that transmits only infrared light, or the like can be used instead of the glass 4.

In the present embodiment, the glass 4 has an outer dimension in plan view smaller than the same outer dimension of the image sensor 3, and is provided within the range of the outer shape of the image sensor 3 in plan view. That is, the glass 4 has an outer dimension slightly smaller than that of the image sensor 3 in plan view, and is provided such that four edge ends of the rectangular shape are positioned inside the four edge ends of the image sensor 3.

For the glass 4 and the image sensor 3 having a rectangular outer shape in plan view, a dimension in a vertical direction and a dimension in a lateral direction of the glass 4 are smaller than a dimension in the vertical direction and a dimension in the lateral direction of the image sensor 3, respectively. Then, the glass 4 is arranged with respect to the image sensor 3, for example, such that centers in a plan view outer shape coincide or substantially coincide with each other. That is, the glass 4 is provided at a position where a peripheral edge portion along four sides of the image sensor 3 protrudes from the periphery of the glass 4 in plan view with respect to the image sensor 3.

The support portion 5 is interposed between the image sensor 3 and the glass 4, and forms the cavity 7 which is a sealed space between the image sensor 3 and the glass 4. The support portion 5 supports the glass 4 in a state of being separated from the image sensor 3, and forms the cavity 7 together with the image sensor 3 and the glass 4.

The support portion 5 is provided in a peripheral region so as to surround the pixel unit 3c on the front surface 3a of the image sensor 3. The support portion 5 has a lower side connected to the front surface 3a of the image sensor 3 and an upper side connected to the back surface 4b of the glass 4. The support portion 5 functions as a sealing portion that hermetically seals the periphery of the cavity 7, and blocks intrusion of moisture (water vapor), dust, and the like from the outside into the cavity 7 together with the glass 4. As described above, the package structure of the imaging device 1 is a structure sealed by the glass 4 and the support portion 5 in order to protect the image sensor 3 from the external environment such as water, humidity, and external force.

The support portion 5 is provided in a wall shape over the entire circumference along the outer shapes of the image sensor 3 and the glass 4 in plan view, and has a rectangular frame shape in plan view and is formed in an endless shape. The support portion 5 is provided at a position within the range of the outer shape of the glass 4 along the outer edge of the glass 4 in plan view. The support portion 5 is provided at a position slightly inside the side surface 4c of the glass 4. However, the support portion 5 may be provided such that its outer surface is substantially flush with the side surface 4c of the glass 4.

The bonding wires 6 are conductive wires that electrically connect the substrate 2 and the image sensor 3. The bonding wires 6 are thin metal wires including, for example, Au (gold), Cu (copper), Al (aluminum), or the like. The bonding wires 6 electrically connect the electrode pads 9 formed on the front surface 2a of the substrate 2 and the electrode pads 10 formed on the front surface 3a of the image sensor 3. For example, the bonding wires 6 rise from the electrode pads 10, forms a convex top portion on the upper side, and has a shape gradually descending toward the electrode pads 9.

A plurality of electrode pads 9 is formed in a predetermined arrangement in a portion outside the mounting portion of the image sensor 3 on the front surface 2a of the substrate 2, and receives connections of one end sides of the bonding wires 6. A plurality of electrode pads 10 is formed in a predetermined arrangement in a portion on an outside of the support portion 5 on the front surface 3a of the image sensor 3, and receives connections of the other end sides of the bonding wires 6.

As the material of the electrode pads 9 and the electrode pads 10, for example, an aluminum material or the like is used. Specifically, the electrode pads 9 and the electrode pads 10 are formed by, for example, covering a layer portion of copper (Cu), tungsten (W), titanium (Ti), or the like with a plating layer of nickel (Ni) and a plating layer of gold (Au). The electrode pads 9 and the electrode pads 10 are formed by appropriately using plating, sputtering, printing, or other film forming methods.

The plurality of electrode pads 9 of the substrate 2 is connected to a plurality of terminal electrodes formed on the back surface 2b side of the substrate 2 via a predetermined wiring portion formed in the substrate 2. Each terminal electrode is provided with a solder ball 12. For example, the solder balls 12 are two-dimensionally arranged in a lattice point shape along the rectangular outer shape of the image sensor 3. The solder balls 12 are used terminals for electrical connection to a circuit board on which the imaging device 1 is mounted in an electronic device in which the imaging device 1 is mounted.

The cavity 7 is a flat rectangular space portion between the image sensor 3 and the glass 4. As for the cavity 7, nitrogen gas ($N_2$ gas) as an inert gas can be enclosed in the cavity 7, or the inside of the cavity 7 can be brought into a vacuum state.

Furthermore, the imaging device 1 includes a covering resin portion 15 provided around the image sensor 3 on the substrate 2. The covering resin portion 15 is a resin portion that covers the bonding wires 6 and connecting portions of the bonding wires 6 to each of the substrate 2 and the image sensor 3. That is, the covering resin portion 15 is formed so as to cover the bonding wires 6, the connecting portions of the bonding wires 6 to the electrode pads 9 of the substrate 2, and the connecting portions of the bonding wires 6 to the electrode pads 10 of the image sensor 3.

The covering resin portion 15 has a side surface portion 15a flush with a side surface 2c of the substrate 2 and an upper surface portion 15b located at a position lower than the front surface 4a of the glass 4. The upper surface portion 15b has a shape gradually lowering from the inside (glass 4 side) to the outside.

The covering resin portion 15 covers and seals the entire periphery of the image sensor 3 and the glass 4 on the substrate 2. Specifically, the covering resin portion 15 covers a peripheral edge portion of the front surface 2a of the substrate 2 where the electrode pads 9 are formed, a side surface 3d of the image sensor 3 and a peripheral edge portion of the front surface 3a where the electrode pads 10 are formed, a side surface on the outside of the support portion 5, and a peripheral edge portion of the back surface 4b and the side surface 4c of the glass 4 in a state where the whole bonding wires 6 are buried.

The covering resin portion 15 is formed by potting using a dispenser. In this case, a resin material to be the covering resin portion 15 is applied to a predetermined portion while being discharged from the nozzle of the dispenser, and then cured to form the covering resin portion 15. However, the covering resin portion 15 may be a portion formed by, for example, injection molding using a mold, or the like. The resin material of the covering resin portion 15 is, for example, a thermosetting resin such as a phenolic resin, a silicone resin, an acrylic resin, an epoxy resin, a urethane resin, a silicon resin, or a polyether amide resin.

In the imaging device 1 having the above configuration, the light transmitted through the glass 4 passes through the cavity 7, and is received and detected by the light receiving elements constituting respective pixels arranged in the pixel unit 3c of the image sensor 3.

The support portion 5 included in the imaging device 1 will be described. The support portion 5 includes a solder layer portion 20 formed by solder. Furthermore, the support portion 5 includes an element-side connection layer portion 21 as a first connection layer portion which is a connecting portion with respect to the image sensor 3, and a glass-side connection layer portion 22 as a second connection layer portion which is a connecting portion with respect to the glass 4.

The solder layer portion 20 is connected to the front surface 3a side of the image sensor 3 via the element-side connection layer portion 21, and is connected to the back surface 4b side of the glass 4 via the glass-side connection layer portion 22. The solder layer portion 20, the element-side connection layer portion 21, and the glass-side connection layer portion 22, which are layer portions forming the support portion 5, have a common planar view outer shape corresponding to the planar view outer shape of the support portion 5.

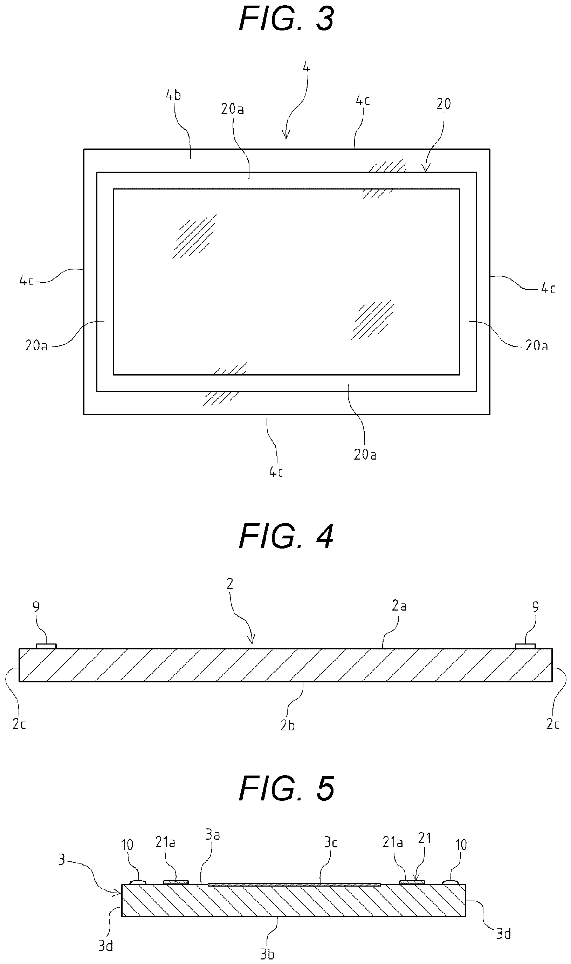

The solder layer portion 20 is a layer portion that is formed using solder as a material and constitutes substantially the entirety of the support portion 5 except upper and lower end surface portions in the support portion 5 formed in the rectangular frame shape in plan view. The solder layer portion 20 has four linear side portions 20a having a predetermined width and forming a rectangular shape corresponding to an outer shape of the rectangular frame shape of the support portion 5 in plan view (see Fig. 3).

The element-side connection layer portion 21 is a layer portion forming a lower end surface portion of the support portion 5 in the support portion 5 formed in the rectangular frame shape in plan view, and is a portion to which a lower side of the solder layer portion 20 is connected. The element-side connection layer portion 21 has four linear side portions 21a having a predetermined width and forming a rectangular shape corresponding to the outer shape of the rectangular frame shape of the support portion 5 in plan view (see Fig. 2).

The element-side connection layer portion 21 is formed on the front surface 3a of the image sensor 3. The element-side connection layer portion 21 is formed in a peripheral region where the support portion 5 is located on the front surface 3a of the image sensor 3. That is, the element-side connection layer portion 21 is formed in a rectangular frame shape at a portion between the pixel unit 3c and an arrangement region of the electrode pads 10.

The element-side connection layer portion 21 is formed as, for example, a plating layer of nickel (Ni), gold (Au), or the like, or a portion having a plating layer of nickel (Ni), gold (Au), or the like. Specifically, the element-side connection layer portion 21 is formed by, for example, covering a layer portion of copper (Cu), tungsten (W), titanium (Ti), or the like with a plating layer of nickel (Ni) and a plating layer of gold (Au). The element-side connection layer portion 21 is formed by appropriately using plating, sputtering, vapor deposition, printing, or other film forming methods.

The element-side connection layer portion 21 is formed simultaneously with the electrode pad 10, for example, as a layer portion common to the electrode pad 10 included in the image sensor 3. However, the element-side connection layer portion 21 may be a portion formed by a step different from the step of forming the electrode pad 10.

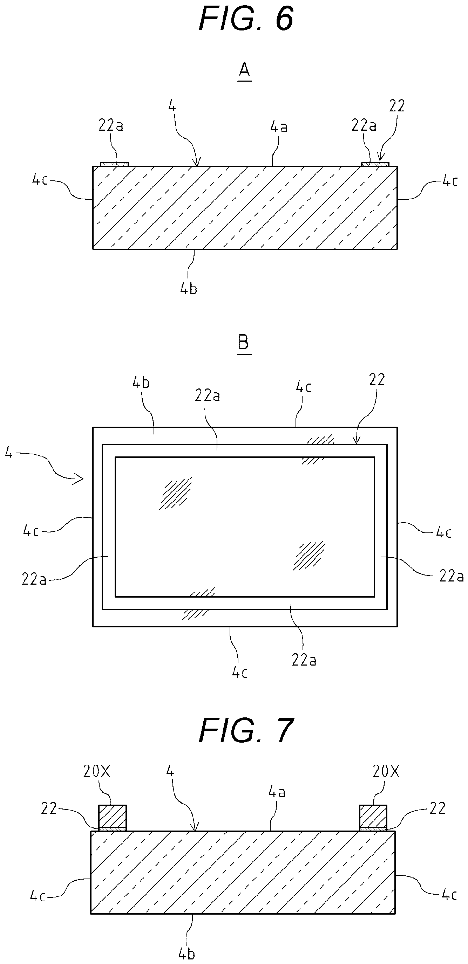

The glass-side connection layer portion 22 is a layer portion forming an upper end surface portion of the support portion 5 in the support portion 5 formed in the rectangular frame shape in plan view, and is a portion to which an upper side of the solder layer portion 20 is connected. Similarly to the element-side connection layer portion 21, the glass-side connection layer portion 22 has four linear side portions 22a having a predetermined width and forming a rectangular shape corresponding to the outer shape of the rectangular frame shape of the support portion 5 in plan view (see Fig. 6B).

The glass-side connection layer portion 22 is formed on the back surface 4b of the glass 4. Similarly to the element-side connection layer portion 21, the glass-side connection layer portion 22 is formed as, for example, a plating layer of nickel (Ni), gold (Au), or the like, or a portion having a plating layer. The glass-side connection layer portion 22 is formed by plating, sputtering, or the like.

<2. Manufacturing method of imaging device according to first embodiment>

A manufacturing method of the imaging device 1 according to the first embodiment of the present technology will be described with reference to Figs. 4 to 8.

In a manufacturing method of the imaging device 1, as illustrated in Fig. 4, a step of preparing the substrate 2 is performed. The substrate 2 is obtained by, for example, dicing a substrate member in which a plurality of substrate portions to be the substrate 2 in the imaging device 1 is two-dimensionally connected. A plurality of electrode pads 9 is formed on the front surface 2a of the substrate 2.

Furthermore, as illustrated in Fig. 5, a step of preparing the image sensor 3 in which the element-side connection layer portion 21 is formed on the light receiving surface side as the imaging element mounted on the substrate 2 is performed. Here, a step of forming the element-side connection layer portion 21 on the front surface 3a side of the image sensor 3 is performed.

That is, in the image sensor 3, the frame-shaped element-side connection layer portion 21 is formed on the front surface 3a side by using a method such as plating or sputtering (see Fig. 2). Furthermore, a plurality of electrode pads 10 is formed on the front surface 3a of the image sensor 3 by using plating or the like in the same step as or in a different step from the step of forming the element-side connection layer portion 21.

Furthermore, a step of preparing, as a transparent member to be mounted on the image sensor 3, the glass 4 on which a solder portion 20X is formed via the glass-side connection layer portion 22 having a shape corresponding to the element-side connection layer portion 21 on one side is performed (see Fig. 7). Here, a step of forming the glass-side connection layer portion 22 on the back surface 4b side of the glass 4 and a step of forming the solder portion 20X using solder as a material on the glass-side connection layer portion 22 are performed.

As illustrated in Figs. 6A and 6B, in the glass 4, the glass-side connection layer portion 22 having a frame shape is formed on the back surface 4b side by using a method such as plating or sputtering (see Fig. 2). After the glass-side connection layer portion 22 is formed on the glass 4, a step of forming the solder portion 20X on the glass-side connection layer portion 22 is performed as illustrated in Fig. 7. The solder portion 20X is a portion to be the solder layer portion 20 of the support portion 5 in the imaging device 1, and is formed on the entire surface of the glass-side connection layer portion 22. That is, the solder portion 20X is formed in a rectangular frame shape corresponding to the shape of the glass-side connection layer portion 22.

The solder portion 20X is formed to have a predetermined thickness by solder plating. However, the solder portion 20X may be formed by another method such as printing. The solder portion 20X is formed so that the solder layer portion 20 is thicker than the element-side connection layer portion 21 and the glass-side connection layer portion 22.

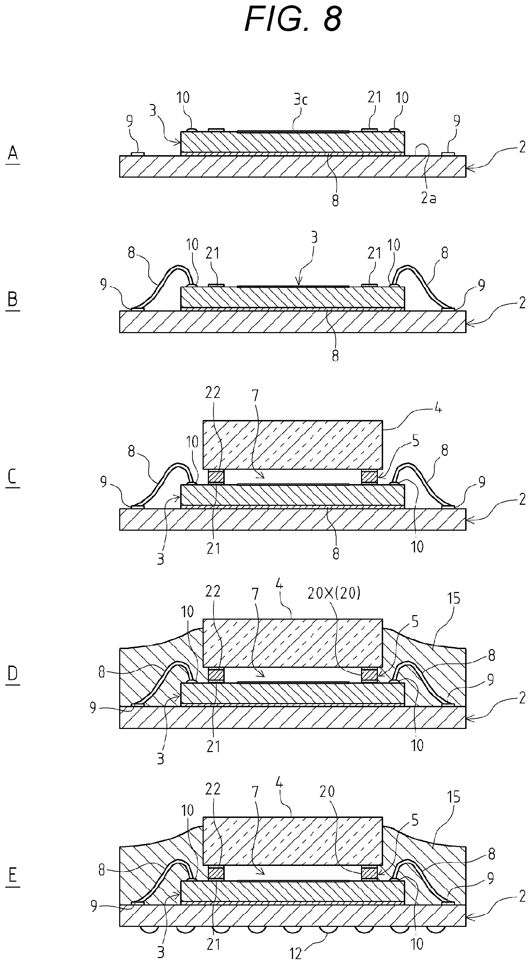

Subsequently, an assembly step is performed. In the assembly step, first, as illustrated in Fig. 8A, a step of mounting the image sensor 3 on the substrate 2 is performed. That is, a die bonding step of die-bonding the image sensor 3 on which the element-side connection layer portion 21 is formed to the substrate 2 prepared as described above is performed. In this step, as illustrated in Fig. 8A, it is bonded to a predetermined mounting portion on the front surface 2a of the substrate 2 by an insulating or conductive resin paste or the like to be the bonding material 8.

Next, as illustrated in Fig. 8B, a step of providing the bonding wires 6 that electrically connect the substrate 2 and the image sensor 3 is performed. Here, a wire bonding step of connecting the electrode pads 9 of the substrate 2 and the electrode pads 10 of the image sensor 3 by the bonding wires 6 to electrically connect them is performed.

Next, as illustrated in Fig. 8C, a step of placing the glass 4 on the image sensor 3 so that the solder portion 20X is positioned on the element-side connection layer portion 21, and melting the solder portion 20X and forming the support portion 5 interposed between the image sensor 3 and the glass 4 to form the cavity 7 is performed.

Specifically, first, the glass 4 is set on the image sensor 3 by a chip mounter or the like so that the element-side connection layer portion 21 and the solder portion 20X are aligned. Thereafter, reflow is performed at a predetermined temperature. That is, the solder portion 20X provided on the glass 4 via the glass-side connection layer portion 22 is used, and the glass 4 is reflow-mounted on the image sensor 3 having the element-side connection layer portion 21. Thus, the solder portion 20X is melted temporarily and solidified to become the solder layer portion 20, the support portion 5 that supports the glass 4 is formed on the image sensor 3, and the image sensor 3 and the glass 4 are brought into a state of being fixed to each other.

In the step of forming the support portion 5 as described above, that is, in the step of reflow-mounting the glass 4, nitrogen gas can be enclosed in the cavity 7. That is, the nitrogen gas is sealed in the cavity 7 by performing reflow processing in the nitrogen atmosphere using a nitrogen atmosphere reflow furnace. Thus, in the imaging device 1, a package structure in which the nitrogen gas is sealed in the cavity 7 is obtained.

Furthermore, in the step of reflow-mounting the glass 4, the inside of the cavity 7 can be evacuated. That is, by performing the reflow processing in a vacuum using a vacuum reflow furnace, the inside of the cavity 7 is brought into a vacuum state. Thus, in the imaging device 1, a package structure in which the inside of the cavity 7 is in a vacuum state is obtained.

After the step of reflow-mounting the glass 4, a step of forming the covering resin portion 15 is performed as illustrated in Fig. 8D. The covering resin portion 15 is formed around the image sensor 3 on the substrate 2 so as to cover the bonding wires 6 and the connecting portions of the bonding wires 6 to each of the substrate 2 and the image sensor 3.

Here, the covering resin portion 15 is formed by a predetermined resin material by potting using a dispenser, and a wire sealing step of sealing the bonding wires 6 is performed. Note that, for example, the covering resin portion 15 may be formed by injection molding using a mold. In the present embodiment, the covering resin portion 15 is formed so as to cover most of the side surface 4c of the glass 4 in the thickness direction of the glass 4.

Then, as illustrated in Fig. 8E, a step of forming a plurality of solder balls 12 on the back surface 2b side of the substrate 2 is performed. Here, a ball mounting step of mounting the solder balls 12 on each of the plurality of terminal electrodes formed on the back surface 2b side of the substrate 2 is performed.

Through the manufacturing step as described above, the imaging device 1 as illustrated in Fig. 1 is obtained.

With the imaging device 1 and the manufacturing method of the same according to the present embodiment as described above, in the configuration in which the glass 4 is mounted on the image sensor 3 with a gap, the image sensor 3 can be downsized, and the package structure can be downsized.

For example, in a case of a configuration in which the glass 4 is mounted on the image sensor 3 via the support portion formed by applying resin, it is necessary to apply the resin to a portion at a certain distance from the pixel unit 3c in order to prevent the resin from being applied to the pixel unit 3c in consideration of thickening of starting and ending points of the applied resin, occurrence of bleeding, and the like. Furthermore, in a case where sufficient mounting accuracy cannot be obtained for mounting the glass 4, it is necessary to secure a certain distance between the pixel unit 3c and the electrode pad 10 in order to avoid interference between the glass 4 and the bonding wires 6. For these reasons, it is necessary to secure a large portion between the pixel unit 3c and the electrode pad 10, and the size of the image sensor 3 increases.

Accordingly, by having the support portion 5 which is mostly the solder layer portion 20, the imaging device 1 of the present embodiment has a GOC structure in which the image sensor 3 and the glass 4 are, so to speak, directly sealed by solder. According to such a configuration, it is not necessary to consider the problem of thickening or bleeding of the starting and ending points of the resin that occurs in a case where the support portion is resin, and the distance between the pixel unit 3c and the electrode pad 10 can be reduced in design. Thus, the image sensor 3 can be downsized, the package size can be reduced, and the cost can be reduced.

Furthermore, by bonding the glass 4 to the image sensor 3 using solder, it is possible to suppress positional displacement of the glass 4 by the action of self-alignment of the solder, and it is possible to improve the mounting accuracy of the glass 4. From such a point as well, the distance between the pixel unit 3c and the electrode pad 10 can be reduced, and the image sensor 3 can be downsized.

Furthermore, with the configuration in which the cavity 7 is hermetically sealed by the solder layer portion 20, it is possible to effectively prevent entry of moisture and the like into the cavity 7 as compared with the case where the support portion is resin, and thus, it is possible to improve reliability of quality. Moreover, with the configuration in which the cavity 7 is hermetically sealed by the solder layer portion 20, since entry of moisture into the cavity 7 can be prevented, it is possible to suppress an increase in the internal pressure of the cavity 7 at the time of reflow processing performed in the manufacturing process of the imaging device 1, and it is possible to obtain high strength of the support portion 5 as compared with a case where the support portion is resin. This makes it possible to reduce the bonding width of the glass 4 with respect to the image sensor 3, and also from such a point, it is possible to contribute to downsizing of the image sensor 3.

Furthermore, the imaging device 1 according to the present embodiment includes the covering resin portion 15 that covers the bonding wires 6 around the image sensor 3 on the substrate 2. According to such a configuration, the amount of resin forming the covering resin portion 15 can be minimized, and the degree of freedom in resin selection can be improved.

That is, in the imaging device 1, since sufficient strength can be secured for the supporting strength of the glass 4 with respect to the image sensor 3 by the solder layer portion 20 constituting the support portion 5, it is not necessary to fix the glass 4 by the covering resin portion 15. Thus, it is sufficient if the covering resin portion 15 is formed to cover the bonding wires 6 and the connecting portions thereof, and the amount of resin can be minimized. Furthermore, in a case where it is not necessary to consider fixing of the glass 4 by the covering resin portion 15, the types of resin applicable to the resin forming the covering resin portion 15 increases, so that the range of resin selection can be expanded. Accordingly, cost reduction or the like can be achieved.

Furthermore, in the imaging device 1 according to the present embodiment, the glass 4 is smaller than the image sensor 3 and is provided within the range of the image sensor 3 in plan view. With such a configuration, a space for wiring of the bonding wires 6 can be easily secured. Thus, the package structure can be made compact.

Furthermore, in the imaging device 1 according to the present embodiment, nitrogen gas can be sealed in the cavity 7 or the inside of the cavity 7 can be brought into a vacuum state. This makes it possible to suppress oxidation of the solder material and the metal components such as the electrode pads 9, for example, in a step of reflow-mounting the glass 4, and the like.

<3. Modification of imaging device according to first embodiment>

A modification of the imaging device 1 according to the present embodiment will be described. Modifications 1 and 2 described below are modifications of the formation mode of the covering resin portion 15. Furthermore, Modification 3 is a modification of the configuration of the support portion 5.

(Modification 1)

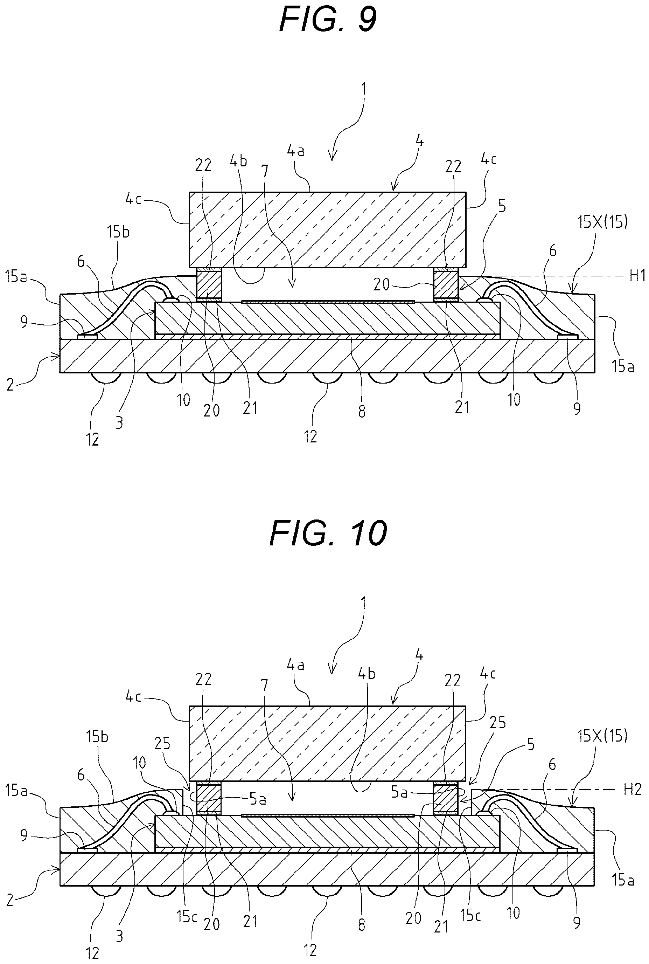

As illustrated in Fig. 9, in Modification 1, a covering resin portion 15X is formed at a position lower than the glass 4 and is not in contact with the side surface 4c of the glass 4. That is, in Modification 1, a height position H1 of the uppermost end of the upper surface portion 15b of the covering resin portion 15X is lower than the back surface 4b of the glass 4. Specifically, the covering resin portion 15X covers the entire bonding wires 6 and the connecting portions thereof, and has an edge end of an inside (inner peripheral side) having the highest height position as a height position up to the vicinity of an upper end of the solder layer portion 20 of the support portion 5 and in contact with a side surface of an outside of the solder layer portion 20.

With the imaging device 1 according to the present embodiment, since the glass 4 can be bonded to the image sensor 3 with high strength by the solder layer portion 20 constituting the support portion 5, it is not necessary to fix the glass 4 with the covering resin portion 15 covering the bonding wires 6. Thus, like the covering resin portion 15X of Modification 1, the covering resin portion 15 can be provided without being in contact with the glass 4.

According to such a configuration, in a case of a configuration in which the covering resin portion 15 is in contact with the side surface 4c of the glass 4, it is possible to suppress occurrence of cracks in the side surface 4c of the glass 4 which may cause a problem in a temperature cycle test, and it is possible to improve the reliability of the device. Furthermore, the amount of resin forming the covering resin portion 15 can be reduced, and the cost can be reduced.

(Modification 2)

As illustrated in Fig. 10, in Modification 2, a covering resin portion 15Y is formed at a position lower than the glass 4, and is not in contact with the side surface 4c of the glass 4 and is not in contact with the support portion 5. In Modification 2, a height position H2 of the uppermost end of the upper surface portion 15b of the covering resin portion 15Y is lower than the back surface 4b of the glass 4. Furthermore, the covering resin portion 15Y is formed so as to have, on an inside (inner peripheral side), a gap 25 from a side surface 5a on the outside of the support portion 5. Specifically, the covering resin portion 15Y covers the entire bonding wires 6 and their connecting portions, and has, on the inside, an inner side end surface 15c facing the side surface 5a on the outside of the support portion 5 with the gap 25 therebetween. Note that the side surface 5a on the outside of the support portion 5 is a surface portion formed by side surfaces on the outside of the solder layer portion 20, the element-side connection layer portion 21, and the glass-side connection layer portion 22.

According to the configuration of Modification 2, as in the configuration of Modification 1, occurrence of cracks in the side surface 4c of the glass 4 can be suppressed, the reliability of the device can be improved, and the amount of resin forming the covering resin portion 15 can be effectively reduced.

(Modification 3)

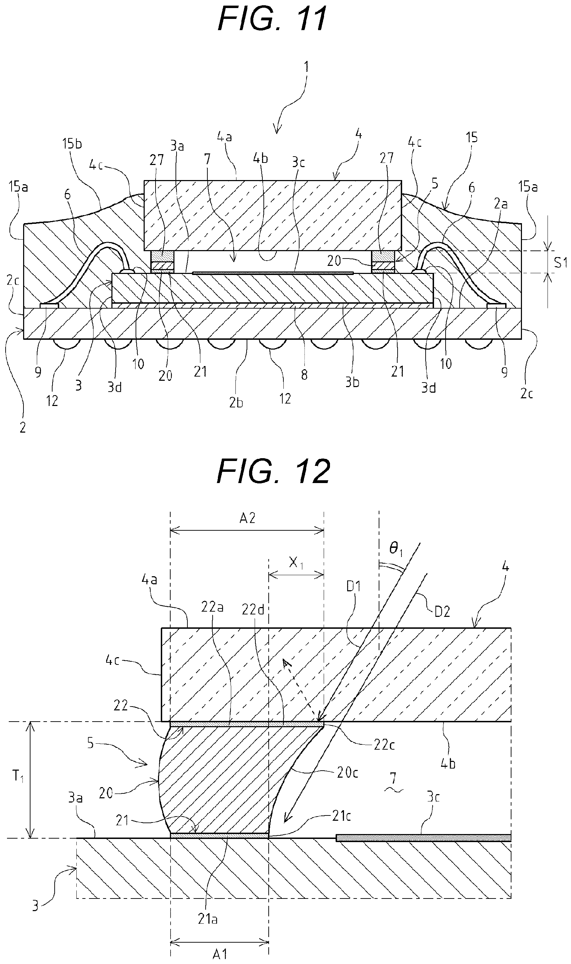

As illustrated in Fig. 11, in Modification 3, the support portion 5 includes a copper layer portion 27 which is a metal layer portion formed by copper or an alloy containing copper on the glass 4 side of the solder layer portion 20. In Modification 3, the copper layer portion 27 is provided instead of the glass-side connection layer portion 22, and constitutes a connecting portion of the support portion 5 with respect to the glass 4. The solder layer portion 20 is formed below the copper layer portion 27. That is, the solder layer portion 20 is provided between the element-side connection layer portion 21 and the copper layer portion 27.

The copper layer portion 27 is a layer portion forming an upper portion of the support portion 5 in the support portion 5 formed in the rectangular frame shape in plan view, and is a portion to which the upper side of the solder layer portion 20 is connected. Similarly to the element-side connection layer portion 21, the copper layer portion 27 has four linear side portions having a rectangular shape corresponding to the outer shape of the rectangular frame shape of the support portion 5 in plan view.

The copper layer portion 27 is formed on the back surface 4b of the glass 4. The copper layer portion 27 is formed by plating, sputtering, vapor deposition, or the like using copper (Cu) or a copper alloy.

With respect to a thickness of the copper layer portion 27 (vertical length in a side cross-sectional view illustrated in Fig. 11), the copper layer portion 27 is formed to have a thickness of, for example, half or substantially half of the entire thickness S1 of the support portion 5. Here, the entire thickness S1 of the support portion 5 corresponds to a distance between the front surface 3a of the image sensor 3 and the back surface 4b of the glass 4. In the example illustrated in Fig. 11, the copper layer portion 27 is formed as a layer portion thicker than the solder layer portion 20.

That is, in the example illustrated in Fig. 11, the support portion 5 includes the copper layer portion 27 having a thickness of half or substantially half of the entire thickness S1 of the support portion 5, the solder layer portion 20 provided under the copper layer portion 27 and thinner than half of the entire thickness S1 of the support portion 5, and the element-side connection layer portion 21 that connects the solder layer portion 20 to the image sensor 3. The copper layer portion 27 may be formed as a layer portion having substantially the same thickness as the solder layer portion 20, or may be formed as a layer portion having a thickness of more than half of the entire thickness S1 of the support portion 5.

In a case of the configuration of Modification 3, in the manufacturing method of the imaging device 1, in the step of preparing the glass 4, the frame-shaped copper layer portion 27 is formed on the back surface 4b side of the glass 4 using a method such as plating or sputtering. After the copper layer portion 27 is formed on the glass 4, a step of forming the solder portion 20X is performed on the copper layer portion 27. The solder portion 20X is formed so that the thickness of the solder layer portion 20 after reflow is thinner than half of the total thickness S1 of the support portion 5. The solder portion 20X is formed on the entire surface of the copper layer portion 27, and is formed in a rectangular frame shape corresponding to the shape of the copper layer portion 27.

According to the configuration of Modification 3, since a portion or most of the thickness of the support portion 5 can be secured by the copper layer portion 27, the thickness of the solder layer portion 20 occupying the entire thickness of the support portion 5 can be reduced. This makes it possible to reduce the layer thickness of the solder portion 20X to be a melted portion in the reflow step, which is the step of forming the support portion 5, and thus the control of the gap between the image sensor 3 and the glass 4 defined by the layer thickness of the support portion 5 can be easily performed.

Note that the surface of the copper layer portion 27 may be covered with, for example, a plating layer of nickel (Ni), gold (Au), or the like. In this case, the plating layer on the surface of the copper layer portion 27 serves as a joint surface portion with the solder layer portion 20.

In addition, the copper layer portion 27 may be provided on the image sensor 3 side with respect to the solder layer portion 20. In this case, the copper layer portion 27 is formed on the front surface 3a of the image sensor 3 by plating or the like instead of the element-side connection layer portion 21, and constitutes a connecting portion of the support portion 5 with respect to the image sensor 3. Moreover, the copper layer portions 27 may be provided on both the glass 4 side and the image sensor 3 side. In this case, the solder layer portion 20 is interposed between the upper and lower copper layer portions 27. As described above, the copper layer portion 27 is only required to be formed on at least one of the upper side or the lower side of the solder layer portion 20.

<4. Configuration example of imaging device according to second embodiment>

A configuration example of an imaging device according to a second embodiment of the present technology will be described. The imaging device according to the present embodiment differs in the configuration of the support portion 5 in comparison with the first embodiment. In the description of each embodiment described below, the same reference numerals are used for parts common to the first embodiment, and the description thereof will be omitted as appropriate.

As illustrated in Fig. 12, in the imaging device according to the present embodiment, in the support portion 5, width dimensions of the element-side connection layer portion 21 and the glass-side connection layer portion 22 are different from each other, and an edge end on an inside of the glass-side connection layer portion 22 is positioned closer to the inside than an edge end on the inside of the element-side connection layer portion 21. Here, the "inside" with respect to the element-side connection layer portion 21 and the glass-side connection layer portion 22 means to be inside with respect to the cavity 7, and is the right side with respect to the support portion 5 illustrated in Fig. 12. Therefore, the "outside" with respect to the element-side connection layer portion 21 and the glass-side connection layer portion 22 means to be outside with respect to the cavity 7, and is the left side with respect to the support portion 5 illustrated in Fig. 12.

Each of the element-side connection layer portion 21 and the glass-side connection layer portion 22 is formed in a frame shape with a predetermined width as a planar shape. In the present embodiment, a width A2 of each side portion 22a forming the frame shape of the glass-side connection layer portion 22 is larger than a width A1 of each side portion 21a forming the frame shape of the element-side connection layer portion 21. Then, the element-side connection layer portion 21 and the glass-side connection layer portion 22 are formed so that edge ends on the outside coincide or substantially coincide with each other in plan view. With such a configuration, in the glass-side connection layer portion 22, an end surface 22c which forms an edge end on an inside thereof is positioned closer to the inside than an end surface 21c which forms an edge end on the inside of the element-side connection layer portion 21 in a planar direction (horizontal direction).

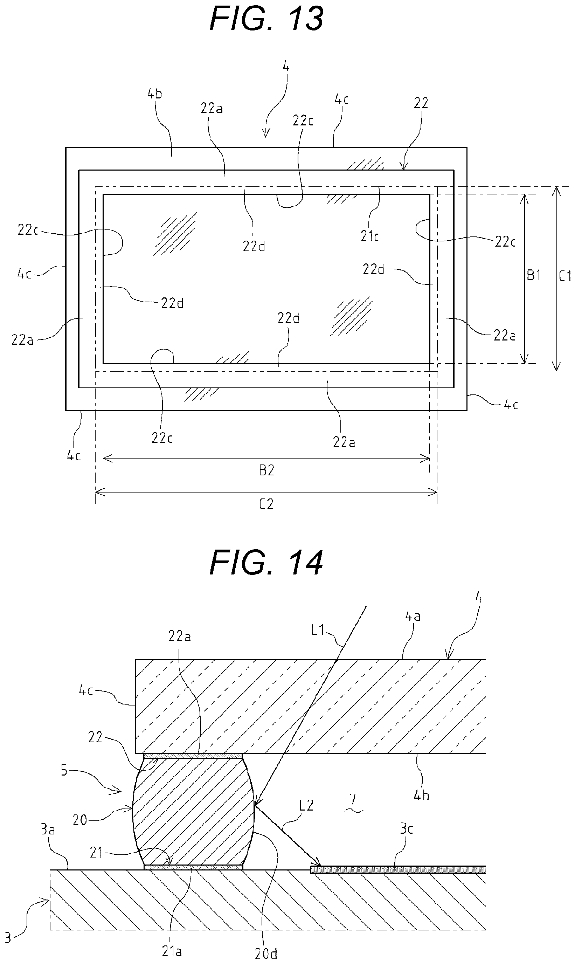

Therefore, in relation to the element-side connection layer portion 21, the glass-side connection layer portion 22 has an extension portion 22d that is a portion protruding inward from the edge end on the inside of the element-side connection layer portion 21 projected vertically to the glass-side connection layer portion 22 in an up-down direction. As illustrated in Fig. 13, the extension portion 22d is an inner edge portion forming the end surface 22c on an inner peripheral side in the glass-side connection layer portion 22, and is formed over the entire periphery along the frame shape of the glass-side connection layer portion 22. Note that, in Fig. 13, an end surface 21c forming an outer shape of the inside of the element-side connection layer portion 21 is indicated by a two-dot chain line.

As illustrated in Fig. 13, in the planar shapes of the element-side connection layer portion 21 and the glass-side connection layer portion 22, a dimension B1 in the vertical direction between the end surfaces 22c on the inside of the side portions 22a of the glass-side connection layer portion 22 facing each other in the vertical direction is smaller than a dimension C1 in the vertical direction between the end surfaces 21c on the inside of the side portions 21a of the element-side connection layer portion 21 facing each other in the vertical direction. Similarly, a dimension B2 in the vertical direction between the end surfaces 22c on the inside of the side portions 22a of the glass-side connection layer portion 22 facing each other in the lateral direction is smaller than a dimension C2 in the vertical direction between the end surfaces 21c on the inside of the side portions 21a of the element-side connection layer portion 21 facing each other in the lateral direction.

In the step of reflow-mounting the glass 4, the solder layer portion 20 has a shape corresponding to the formation region of the element-side connection layer portion 21 and the glass-side connection layer portion 22 due to surface tension of the solder or the like. In the support portion 5 according to the present embodiment, since the glass-side connection layer portion 22 has the extension portion 22d in relation to the element-side connection layer portion 21, the solder layer portion 20 has an inner surface 20c as an inclined surface gradually extending from the inside to the outside and from the upper side to the lower side (see Fig. 12). That is, the inner surface 20c is inclined so that a space portion inside the frame-shaped solder layer portion 20 spreads downward. The inner surface 20c of the solder layer portion 20 has, for example, a curved surface shape forming a concave shape in a side cross-sectional view as illustrated in Fig. 12.

With the imaging device 1 including the support portion 5 according to the present embodiment, the glass-side connection layer portion 22 positioned above the element-side connection layer portion 21 formed on the front surface 3a of the image sensor 3 has the inward extension portion 22d. With such a configuration, since it is possible to suppress the incident light transmitted through the glass 4 from hitting the inner surface 20c of the solder layer portion 20, it is possible to suppress generation of noise such as what is called flare caused by the reflected light from the inner surface 20c being incident on the pixel unit 3c.

For example, as illustrated in Fig. 14, in the configuration in which the glass-side connection layer portion 22 does not have the extension portion 22d, there is a problem that incident light L1 transmitted through the glass 4 easily hits an inner surface 20d of the solder layer portion 20 and reflected light L2 is incident on the pixel unit 3c. The reflected light L2 incident on the pixel unit 3c causes noise such as flare in the image. For example, in a case where the support portion that supports the glass 4 is a portion entirely formed by resin, in order to prevent incident light on the inner side surface of the support portion, it is necessary to take measures such as forming a light shielding film such as a metal film or an organic film that reflects light on the glass 4.

Therefore, as in the support portion 5 according to the present embodiment, by forming the extension portion 22d in the glass-side connection layer portion 22 by adjusting the width dimension of the upper and lower connection layer portions (21 and 22) of the solder layer portion 20, the extension portion 22d can shield incident light D1 that attempts to hit the inner surface of the solder layer portion 20 by reflecting the incident light D1, and the like (see Fig. 12).

Furthermore, since the glass-side connection layer portion 22 has the extension portion 22d in relation to the element-side connection layer portion 21, the inner surface 20c of the solder layer portion 20 gradually becomes an inclined surface from the inside to the outside and from the upper side to the lower side. Thus, it is possible to prevent incident light D2 passing through the glass 4 into the cavity 7 from hitting the inner surface 20c of the solder layer portion 20 (see Fig. 12). Furthermore, even in a case where the light transmitted through the glass 4 hits the inner surface 20c of the solder layer portion 20, the inclined shape of the inner surface 20c can suppress the reflected light from the inner surface 20d from reaching the pixel unit 3c.

As described above, according to the support portion 5 of the present embodiment, the incident light can be prevented from hitting the inner surface 20c of the solder layer portion 20, and the incident light hitting the inner surface 20c can be prevented from being reflected and entering the pixel unit 3c. Thus, noise can be reduced, and the quality of an image obtained by the imaging device 1 can be improved.

An extension length of the extension portion 22d of the glass-side connection layer portion 22 with respect to the element-side connection layer portion 21, that is, a width dimension $X_1$ of the extension portion 22d is determined on the basis of, for example, the following relationship. As illustrated in Fig. 12, in a case where the magnitude of an incident angle of incident light that may cause noise with respect to the pixel unit 3c is $\theta_1$, and

the thickness of the support portion 5, that is, a length of an interval between the front surface 3a of the image sensor 3 and the back surface 4b of the glass 4 is Ti, the following Expression (1) holds. Note that the incident angle $\theta_1$ is an angle of the incident light with respect to the vertical direction in a side cross-sectional view as illustrated in Fig. 13.

$$X_1 = T_1 \cdot \tan\theta_1 \ ...(1)$$

As described above, the width dimension $X_1$ of the extension portion 22d is determined by the length $T_1$ of the interval between the image sensor 3 and the glass 4 with respect to the incident angle $\theta_1$ of the incident light. Then, the width dimension $X_1$ of the extension portion 22d is preferably set to a length equal to or more than the value derived by Expression (1). Specifically, on the basis of Expression (1), for example, in a case where $T_1$ = 100 [$\mu$m] and $\theta_1$ = 30[°], $X_1 \approx 58$ $\mu$m.

On the other hand, regarding the upper limit of the width dimension $X_1$ of the extension portion 22d, the length is limited so that the incident light to the pixel unit 3c is not blocked. The extension portion 22d is formed, for example, so that the edge ends on the inside of the glass-side connection layer portion 22 do not overlap the pixel unit 3c in plan view, that is, so that the end surfaces 22c on the inside of the glass-side connection layer portion 22 are positioned outside the pixel unit 3c in the planar direction. Therefore, in a case of the above-described numerical example related to Expression (1), the width dimension $X_1$ of the extension portion 22d is preferably set to a length of 58 $\mu$m or more within a range in which the glass-side connection layer portion 22 does not overlap the pixel unit 3c.

<5. Modification of imaging device according to second embodiment>

A modification of the support portion 5 according to the present embodiment will be described. From the viewpoint of suppressing the incidence of light on the pixel unit 3c that becomes noise as described above, the glass-side connection layer portion 22 is only required to have a portion protruding inward from the inner end surface 21c of the element-side connection layer portion 21 in the planar direction. Therefore, the support portion 5 according to the present embodiment may have the following configuration.

(Modification 1)

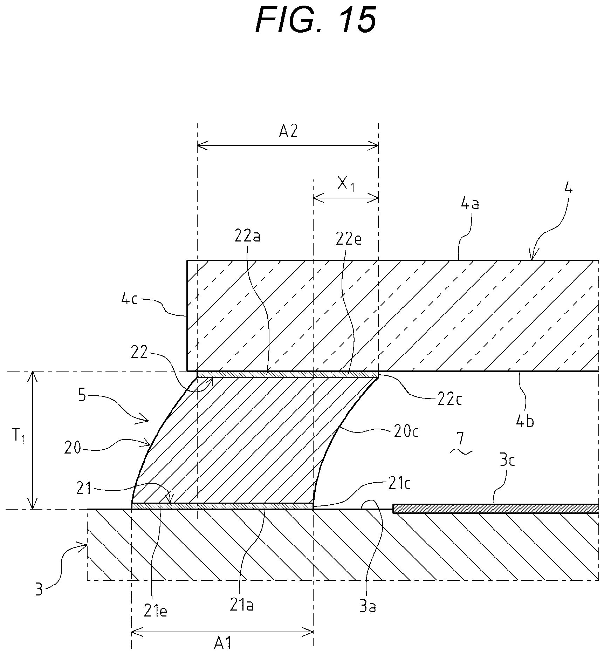

As illustrated in Fig. 15, in Modification 1, the width dimensions of the element-side connection layer portion 21 and the glass-side connection layer portion 22 of the support portion 5 are the same as each other, and the positions of both connection layer portions in the width direction (left-right direction in Fig. 15) are shifted, so that the edge end on the inside of the glass-side connection layer portion 22 is positioned closer to the inside than the edge end on the inside of the element-side connection layer portion 21.

In Modification 1, the width A2 of each side portion 22a of the glass-side connection layer portion 22 is the same as the width A1 of each side portion 21a of the element-side connection layer portion 21. Then, by forming the glass-side connection layer portion 22 inside the element-side connection layer portion 21, the end surfaces 22c on the inside of the glass-side connection layer portion 22 are positioned inside the end surfaces 21c on the inside of the element-side connection layer portion 21 in the planar direction.

Therefore, in relation to the element-side connection layer portion 21, the glass-side connection layer portion 22 has a protruding portion 22e that is a portion protruding inward from the edge end on the inside of the element-side connection layer portion 21 projected vertically to the glass-side connection layer portion 22 in the up-down direction. Furthermore, the element-side connection layer portion 21 has a protruding portion 21e that is a portion protruding outward from an edge end on the outside of the glass-side connection layer portion 22 projected vertically to the element-side connection layer portion 21 in the up-down direction in relation to the glass-side connection layer portion 22.

The element-side connection layer portion 21 and the glass-side connection layer portion 22 have a common positional relationship with respect to the four side portions 21a and 22a forming the frame shape. Therefore, in Modification 1, the glass-side connection layer portion 22 is formed entirely inside the element-side connection layer portion 21 while having the same widths of respective side portions in relation to the element-side connection layer portion 21. In the configuration of Modification 1, the width dimension of the protruding portion 22e to the inside of the glass-side connection layer portion 22 is the width dimension $X_1$ in the above-described Expression (1).

According to the configuration of Modification 1, as in the case where the glass-side connection layer portion 22 has the extension portion 22d, noise can be reduced by the protruding portion 22e to the inside of the glass-side connection layer portion 22. Furthermore, in comparison with the configuration in which the extension portion 22d is provided, since the connection area of the support portion 5 with respect to the image sensor 3 can be increased by the amount that the element-side connection layer portion 21 has the protruding portion 21e to the outside, it is easy to secure the bonding strength of the support portion 5.

(Modification 2)

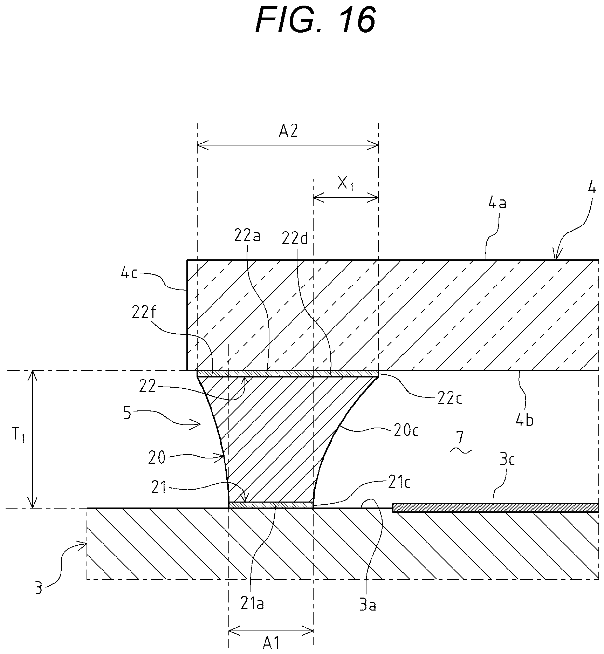

As illustrated in Fig. 16, in Modification 2, in the configuration in which the extension portion 22d is provided in the glass-side connection layer portion 22 (see Fig. 12), the support portion 5 has the outer edge end of the element-side connection layer portion 21 positioned inside the edge end on the outside of the glass-side connection layer portion 22.

In Modification 2, the width A2 of each side portion 22a of the glass-side connection layer portion 22 is larger than the width A1 of each side portion 21a of the element-side connection layer portion 21. Then, in relation to the element-side connection layer portion 21, the glass-side connection layer portion 22 has a protruding portion 22f that is a portion protruding outward from the edge end on the outside of the element-side connection layer portion 21 projected vertically to the glass-side connection layer portion 22 in the up-down direction.

The element-side connection layer portion 21 and the glass-side connection layer portion 22 have a common positional relationship with respect to the four side portions 21a and 22a forming the frame shape. Therefore, in Modification 2, the entire element-side connection layer portion 21 is included in the formation range of the glass-side connection layer portion 22 in plan view.

According to the configuration of Modification 2, noise can be reduced by the extension portion 22d of the glass-side connection layer portion 22, and the area occupied by the element-side connection layer portion 21 on the front surface 3a of the image sensor 3 can be reduced, so that the image sensor 3 can be downsized.

<6. Configuration example of imaging device according to third embodiment>

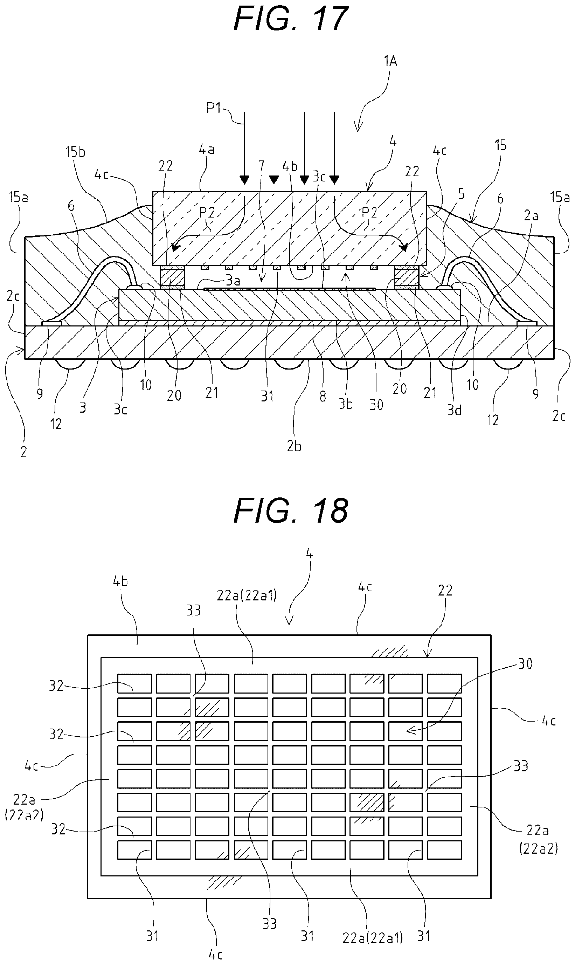

A configuration example of an imaging device according to a third embodiment of the present technology will be described. As illustrated in Figs. 17 and 18, an imaging device 1A according to the present embodiment includes a fine wiring portion 30 provided on the back surface 4b that is a surface of the glass 4 on the cavity 7 side. The fine wiring portion 30 is connected to the GND potential of the image sensor 3 via the support portion 5.

The fine wiring portion 30 is formed in a mesh shape as the same layer portion as the glass-side connection layer portion 22 on the back surface 4b side of the glass 4. Therefore, the fine wiring portion 30 is formed on the back surface 4b of the glass 4 simultaneously with the glass-side connection layer portion 22 by, for example, plating, sputtering, or the like using the same material as the glass-side connection layer portion 22. However, the fine wiring portion 30 may be a portion formed by a material different from that of the glass-side connection layer portion 22. The fine wiring portion 30 includes a plurality of linear wiring portions (31, 32) arranged in a lattice shape along the frame shape of the glass-side connection layer portion 22 and inside the glass-side connection layer portion 22.

The fine wiring portion 30 includes, as a plurality of wiring portions forming a lattice shape, a plurality of first wiring portions 31 along a transverse direction (up-down direction in Fig. 18) in the plate surface shape of the glass 4 and a plurality of second wiring portions 32 along a longitudinal direction (left-right direction in Fig. 18) in the plate surface shape of the glass 4. The plurality of first wiring portions 31 and the plurality of second wiring portions 32 are arranged in parallel at predetermined intervals. The first wiring portions 31 and the second wiring portions 32 are orthogonal to each other and form intersection portions 33. These wiring portions are formed to have a line width narrower than the width of the side portion 22a of the glass-side connection layer portion 22.

Both ends of the first wiring portions 31 are connected to a pair of longitudinal side portions 22a1 facing each other in the transverse direction of the glass 4 among the side portions 22a of the glass-side connection layer portion 22. That is, the first wiring portions 31 are formed as the same layer portions as the glass-side connection layer portion 22 in a mode of being bridged between the pair of side portions 22a1. Both ends of the second wiring portions 32 are connected to a pair of transverse side portions 22a2 facing each other in the longitudinal direction of the glass 4 among the side portions 22a of the glass-side connection layer portion 22. That is, the second wiring portion 32 are formed as the same layer portions as the glass-side connection layer portion 22 in a mode of being bridged between the pair of side portions 22a2.

As described above, the fine wiring portion 30 is formed as a portion electrically connected to the glass-side connection layer portion 22 forming the upper end of the support portion 5, and is connected to the GND potential which is a constant potential of the image sensor 3. That is, in the present embodiment, the element-side connection layer portion 21 forming the lower end of the support portion 5 is formed as an electric conductor wiring portion connected to the GND potential of the image sensor 3 via a predetermined wiring portion. Then, the solder layer portion 20 formed on the element-side connection layer portion 21 is a portion that electrically connects the element-side connection layer portion 21 and the glass-side connection layer portion 22.

Thus, the fine wiring portion 30 is connected to the GND potential of the image sensor 3 via conductive portions including the glass-side connection layer portion 22, the solder layer portion 20, and the element-side connection layer portion 21 constituting the support portion 5. That is, both the support portion 5 and the fine wiring portion 30 are portions having the same potential as the GND potential.

Most of the fine wiring portion 30 is formed in a portion covering the pixel unit 3c of the image sensor 3 in the glass 4. Thus, the first wiring portions 31 and the second wiring portions 32 are formed as fine wirings that do not affect the image obtained by the image sensor 3. Specifically, the first wiring portions 31 and the second wiring portions 32 are formed with a line width of 0.15 to 1 $\mu$m, for example, and are preferably formed with a line width of 0.15 to 0.5 $\mu$m that is invisible to the naked eye.

Further, the thicknesses of the first wiring portions 31 and the second wiring portions 32 are, for example, 50 nm to 1 $\mu$m. Furthermore, the pitch between the wiring portions of the plurality of first wiring portions 31 and the plurality of second wiring portions 32 is, for example, 2 to 10 $\mu$m.

<7. Manufacturing method of imaging device according to third embodiment>

In a manufacturing method of the imaging device 1A according to the third embodiment of the present technology, in the step of preparing the image sensor 3, the element-side connection layer portion 21 is formed as a portion connected to the GND potential of the image sensor 3 via a predetermined wiring portion.

Furthermore, the step of preparing the glass 4 includes a step of forming the fine wiring portion 30 on the back surface 4b of the glass 4. The fine wiring portion 30 is formed simultaneously with the glass-side connection layer portion 22 by plating, sputtering, or the like in a step of forming the glass-side connection layer portion 22. However, the fine wiring portion 30 may be formed in a step different from the step of forming the glass-side connection layer portion 22. In this case, the fine wiring portion 30 may be formed by a material different from the material forming the glass-side connection layer portion 22. As a material of the fine wiring portion 30, for example, silver (Ag), aluminum (Al), platinum (Pt), copper (Cu), nickel (Ni), or the like is used. Other steps are common to the manufacturing method of the imaging device 1 of the first embodiment.

With the imaging device 1A according to the present embodiment, in addition to the effects obtained by the imaging device 1 according to the first embodiment, electromagnetic noise incident from the front surface 4a of the glass 4 can be shielded, and electromagnetic noise affecting the image sensor 3 can be reduced.

As illustrated in Fig. 17, in an electronic device on which the imaging device 1 is mounted, electromagnetic noise may enter the imaging device 1A from the front surface 4a side of the glass 4 (see arrows P1). The electromagnetic noise incident on the glass 4 propagates in the glass 4 and is radiated (see arrows P2), and may adversely affect the sensor characteristics of the image sensor 3.

Therefore, as in the imaging device 1A according to the present embodiment, by arranging the fine wiring portion 30 on the back surface 4b of the glass 4 and connecting the fine wiring portion to the GND potential on the image sensor 3, the electromagnetic noise incident on the glass 4 can be absorbed and shielded without blocking the incident light to the pixel unit 3c, and the influence of the electromagnetic noise on the image sensor 3 can be reduced. Thus, the noise resistance of the imaging device 1A can be improved. Note that a wiring portion group of the first wiring portions 31 and the second wiring portions 32 constituting the fine wiring portion 30 is only required to be formed in a mesh shape, and may be formed in an oblique direction with respect to the frame shape of the glass-side connection layer portion 22, for example.

<8. Configuration example of imaging device according to fourth embodiment>

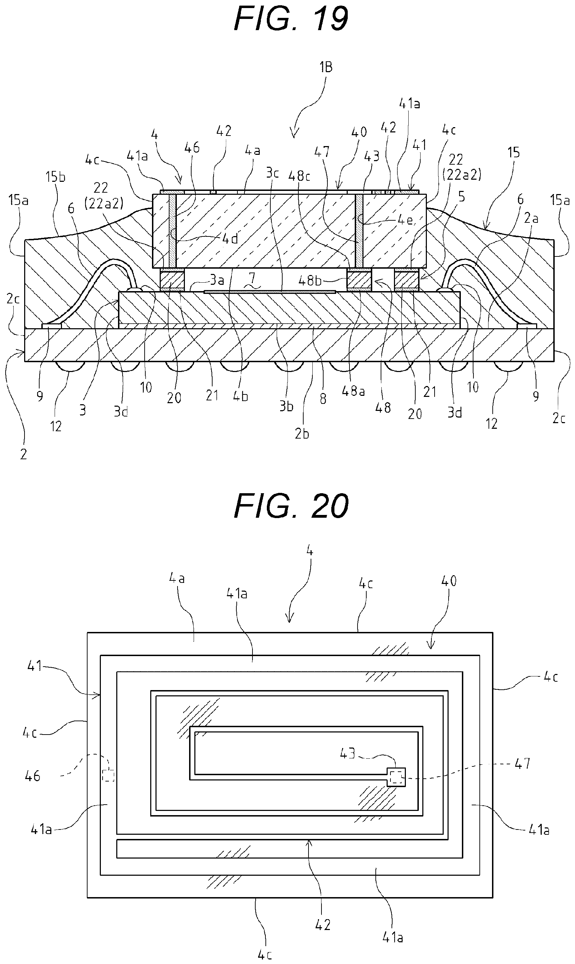

A configuration example of an imaging device according to a fourth embodiment of the present technology will be described. As illustrated in Figs. 19 and 20, an imaging device 1B according to the present embodiment includes a heat-generating fine wiring portion 40 provided on a front surface 4a that is a surface of the glass 4 opposite to the cavity 7 side. The heat-generating fine wiring portion 40 is a wiring portion that is electrically connected to the support portion 5 and generates heat by receiving supply of a current from the image sensor 3.

The heat-generating fine wiring portion 40 is formed as a layered portion on the front surface 4a of the glass 4 by, for example, plating, sputtering, or the like using the same material as the glass-side connection layer portion 22. However, the heat-generating fine wiring portion 40 may be a portion formed by a material different from that of the glass-side connection layer portion 22.

The heat-generating fine wiring portion 40 includes an outer frame portion 41, a fine wiring portion 42, and a connecting portion 43. The outer frame portion 41, the fine wiring portion 42, and the connecting portion 43 form the heat-generating fine wiring portion 40 as an integrally continuous electric conductor wiring portion.

The outer frame portion 41 is formed in a rectangular frame shape along the outer shape of the glass 4, and has four linear side portions 41a having a predetermined width and forming a rectangular shape. The outer frame portion 41 has, for example, a shape and dimensions similar to those of glass-side connection layer portion 22, and is formed so as to overlap glass-side connection layer portion 22 in plan view.

The fine wiring portion 42 is a fine linear wiring portion formed in a spiral shape while forming a right-angle corner portion by a plurality of linear portions along the frame shape of the outer frame portion 41. The fine wiring portion 42 is formed to have a line width narrower than the width of the side portion 41a of the outer frame portion 41.

The fine wiring portion 42 connects an end on one side located on an outer peripheral side in a spiral shape to the outer frame portion 41. The end on one side of the fine wiring portion 42 is connected to the vicinity of one corner (lower left corner in Fig. 20) of the outer frame portion 41. The fine wiring portion 42 connects an end on the other side located on an inner peripheral side in the spiral shape to the connecting portion 43.

The connecting portion 43 is a pad-shaped wiring portion having a quadrangular shape. The connecting portion 43 has, for example, a square shape in which the length of one side is substantially the same as the width dimension of the side portion 41a of the outer frame portion 41. The connecting portion 43 is formed at a position corresponding to a peripheral region that is a region outside the pixel unit 3c of the image sensor 3 in plan view. In the example illustrated in Fig. 20, the connecting portion 43 is formed at a substantially central position in the transverse direction of the glass 4 and at a position closer to the right side in the longitudinal direction of the glass 4.

As described above, in the heat-generating fine wiring portion 40, one end side of the fine wiring portion 42 is connected to the outer frame portion 41, and the other end side of the fine wiring portion 42 is connected to the connecting portion 43. The heat-generating fine wiring portion 40 is electrically connected to the support portion 5 by a first through-wiring portion 46 which is a first connection wiring portion provided on the glass 4.

The first through-wiring portion 46 is a wiring portion embedded in a first through hole 4d formed so as to penetrate the glass 4 in a plate thickness direction. A lower end side of the first through-wiring portion 46 is electrically connected to the glass-side connection layer portion 22, and an upper end side thereof is electrically connected to the outer frame portion 41 of the heat-generating fine wiring portion 40. The first through-wiring portion 46 is formed by, for example, the same material as the glass-side connection layer portion 22 by plating, sputtering, or the like.

In the present embodiment, the first through hole 4d is a rectangular through hole smaller than the width of the side portion 41a, and the first through-wiring portion 46 is formed in a quadrangular columnar shape. The first through-wiring portion 46 is located at an intermediate portion of one transverse side portion 22a2 among the side portions 22a of the glass-side connection layer portion 22 in plan view.

However, the first through-wiring portion 46 is only required to be provided so as to electrically connect the glass-side connection layer portion 22 and the outer frame portion 41, and the shape and formation portion of the first through-wiring portion 46 are not particularly limited. In addition, the first connection wiring portion that electrically connects the glass-side connection layer portion 22 and the outer frame portion 41 may be provided outside the glass 4 along the front surface 4a, the side surface 4c, and the back surface 4b of the glass 4, for example.

As described above, the heat-generating fine wiring portion 40 is formed as a portion electrically connected to the glass-side connection layer portion 22 forming the upper end of the support portion 5 via the first through-wiring portion 46, and is connected to a first potential of the image sensor 3. That is, in the present embodiment, the element-side connection layer portion 21 forming the lower end of the support portion 5 is formed as an electric conductor wiring portion connected to the first potential of the image sensor 3 via a predetermined wiring portion. Then, the solder layer portion 20 formed on the element-side connection layer portion 21 electrically connects the element-side connection layer portion 21 and the glass-side connection layer portion 22, and the glass-side connection layer portion 22 and the outer frame portion 41 of the heat-generating fine wiring portion 40 are connected by the first through-wiring portion 46.

On the other hand, the heat-generating fine wiring portion 40 is connected to the image sensor 3 at a second potential different from the first potential to which the support portion 5 is connected. As a configuration for connecting the heat-generating fine wiring portion 40 to the second potential of the image sensor 3, the imaging device 1B includes a second through-wiring portion 47 which is a second connection wiring portion provided on the glass 4, and an interposed conductive portion 48 interposed between the glass 4 and the image sensor 3.

Similarly to the first through-wiring portion 46, the second through-wiring portion 47 is a wiring portion embedded in the second through hole 4e formed so as to penetrate the glass 4 in the plate thickness direction. A lower end side of the second through-wiring portion 47 is electrically connected to the interposed conductive portion 48, and an upper end side thereof is electrically connected to the connecting portion 43 of the heat-generating fine wiring portion 40. The second through-wiring portion 47 is formed by, for example, the same material as the glass-side connection layer portion 22 by plating, sputtering, or the like.

In the present embodiment, the second through hole 4e is a rectangular through hole smaller than the width of the side portion 41a, and the second through-wiring portion 47 is formed in a quadrangular columnar shape. The second through-wiring portion 47 is located at the center of the connecting portion 43 in plan view.

However, the second through-wiring portion 47 is only required to be provided so as to electrically connect the connecting portion 43 and the interposed conductive portion 48, and the shape and the formation portion of the second through-wiring portion 47 are not particularly limited. In addition, the second connection wiring portion that electrically connects the connecting portion 43 and the second through-wiring portion 47 may be provided outside the glass 4 along the front surface 4a, the side surface 4c, and the back surface 4b of the glass 4, for example.

The interposed conductive portion 48 is a portion that electrically connects the second through-wiring portion 47 and a portion of the second potential of the image sensor 3. The interposed conductive portion 48 is formed at a position corresponding to a peripheral region which is a region outside the pixel unit 3c of the image sensor 3. The interposed conductive portion 48 is provided between the back surface 4b of the glass 4 and the front surface 3a of the image sensor 3. The interposed conductive portion 48 is, for example, a portion having a quadrangular columnar outer shape, and has the same shape and dimensions as those of the connecting portion 43 in plan view so as to overlap with the connecting portion 43 of the heat-generating fine wiring portion 40 in plan view. Note that the shape, dimension, and the like of the interposed conductive portion 48 are not particularly limited.

The interposed conductive portion 48 has a layer structure similar to that of the support portion 5. That is, the interposed conductive portion 48 includes a lower connection layer portion 48a formed on the front surface 3a of the image sensor 3 as the same layer portion as the element-side connection layer portion 21, an intermediate layer portion 48b formed as the same layer portion as the solder layer portion 20, and an upper connection layer portion 48c formed on the back surface 4b of the glass 4 as the same layer portion as the glass-side connection layer portion 22.

The lower connection layer portion 48a of the interposed conductive portion 48 is formed as an electric conductor wiring portion connected to the second potential of the image sensor 3 via a predetermined wiring portion. The intermediate layer portion 48b formed on the lower connection layer portion 48a is a portion that electrically connects the lower connection layer portion 48a and the upper connection layer portion 48c. Then, to the interposed conductive portion 48, the lower end side of the second through-wiring portion 47 is connected in the upper connection layer portion 48c. Therefore, the upper connection layer portion 48c of the interposed conductive portion 48 and the connecting portion 43 of the heat-generating fine wiring portion 40 are connected by the second through-wiring portion 47.

In this manner, the heat-generating fine wiring portion 40 is connected to the second potential of the image sensor 3 via the second through-wiring portion 47 and the interposed conductive portion 48. Thus, the heat-generating fine wiring portion 40 is connected to the first potential of the image sensor 3 via the first through-wiring portion 46 and the support portion 5, and is connected to the second potential of the image sensor 3 via the second through-wiring portion 47 and the interposed conductive portion 48. Therefore, a current supplied from the image sensor 3 flows through the heat-generating fine wiring portion 40.

The heat-generating fine wiring portion 40 receives supply of a current from the image sensor 3 via the support portion 5 and the first through-wiring portion 46 or receives supply of a current from the image sensor 3 via the interposed conductive portion 48 and the second through-wiring portion 47 according to a potential difference between the first potential and the second potential. In the heat-generating fine wiring portion 40, for example, one of the outer frame portion 41 and the connecting portion 43 is connected to a minus side of a predetermined circuit such as a drive circuit or the like included in the image sensor 3, and the other of the outer frame portion 41 and the connecting portion 43 is connected to a plus side of the predetermined circuit.

Most of the fine wiring portion 42 of the heat-generating fine wiring portion 40 is formed in a portion covering the pixel unit 3c of the image sensor 3 in the glass 4. Thus, the fine wiring portion 42 is formed as a fine wiring that does not affect the image obtained by the image sensor 3. Specifically, the fine wiring portion 42 is formed with a line width of 0.15 to 1 $\mu$m, for example, and is preferably formed with a line width of 0.15 to 0.5 $\mu$m that is invisible to the naked eye. Further, the thickness of the heat-generating fine wiring portion 40 is, for example, 50 nm to 1 $\mu$m. Furthermore, in the heat-generating fine wiring portion 40, an interval between adjacent wiring portions is, for example, 2 to 10 $\mu$m.

<9. Manufacturing method of imaging device according to fourth embodiment>

In a manufacturing method of the imaging device 1B according to the fourth embodiment of the present technology, in the step of preparing the image sensor 3, the element-side connection layer portion 21 is formed as a portion connected to the first potential of the image sensor 3 via a predetermined wiring portion. Furthermore, on the front surface 3a of the image sensor 3, a lower connection layer portion 48a forming a lower end of the interposed conductive portion 48 is formed as a portion connected to the second potential of the image sensor 3 via predetermined wiring.

Furthermore, the step of preparing the glass 4 includes a step of forming the heat-generating fine wiring portion 40 on the front surface 4a of the glass 4. The heat-generating fine wiring portion 40 is formed by plating, sputtering, or the like. As a material of the heat-generating fine wiring portion 40, for example, silver (Ag), aluminum (Al), platinum (Pt), copper (Cu), nickel (Ni), or the like is used.

Furthermore, the step of preparing the glass 4 includes a step of forming the first through-wiring portion 46 and the second through-wiring portion 47. Here, first, a step of forming the first through hole 4d and the second through hole 4e on the glass 4 by etching or the like is performed. Thereafter, the first through-wiring portion 46 and the second through-wiring portion 47 are formed by embedding a conductive material in each of the first through hole 4d and the second through hole 4e by plating, sputtering, or the like.

Furthermore, in the step of preparing the glass 4, a step of forming the upper connection layer portion 48c on the back surface 4b side of the glass 4 and a step of forming a solder portion using solder as a material as a portion to be the intermediate layer portion 48b on the upper connection layer portion 48c are performed. The step of forming the upper connection layer portion 48c is, for example, the same step as the step of forming the glass-side connection layer portion 22, and the upper connection layer portion 48c is formed together with the glass-side connection layer portion 22. Furthermore, the step of forming the solder portion to be the intermediate layer portion 48b is, for example, the same step as the step of forming the solder portion 20X (see Fig. 7), and the solder portion to be the intermediate layer portion 48b is formed on the upper connection layer portion 48c together with the solder portion 20X.

Then, in the step of reflow-mounting the glass 4, the glass 4 is placed on the image sensor 3 so that the solder portion to be the intermediate layer portion 48b is positioned on the lower connection layer portion 48a, and the solder portion to be the intermediate layer portion 48b is melted to form the interposed conductive portion 48 interposed between the image sensor 3 and the glass 4. That is, the solder portion interposed between the lower connection layer portion 48a and the upper connection layer portion 48c is melted temporarily and solidified to become the intermediate layer portion 48b, and the interposed conductive portion 48 is formed simultaneously with the support portion 5. Here, in the same step as the reflow of the solder portion 20X, the solder portion to be the intermediate layer portion 48b is reflowed, and the intermediate layer portion 48b is formed together with the solder layer portion 20. Other steps are common to the manufacturing method of the imaging device 1 of the first embodiment.

With the imaging device 1B according to the present embodiment, it is possible to suppress the occurrence of dew condensation on the front surface 4a of the glass 4 in addition to the operational effects obtained by the imaging device 1 according to the first embodiment.

That is, as in the imaging device 1B according to the present embodiment, by arranging the heat-generating fine wiring portion 40 on the front surface 4a of the glass 4 and supplying a current from the image sensor 3 to the heat-generating fine wiring portion 40 to cause the heat-generating fine wiring portions to generate heat, the glass 4 can be heated, and dew condensation generated on the front surface 4a of the glass 4 can be reduced. Accordingly, fogging and freezing of the glass 4 can be suppressed without blocking incident light to the pixel unit 3c. Note that the form of the wiring of the heat-generating fine wiring portion 40 is not limited to the present embodiment. The heat-generating fine wiring portion 40 is only required to be provided so as not to block light incident on the pixel units 3c and so as to entirely heat the glass 4.

<10. Configuration example of electronic device>

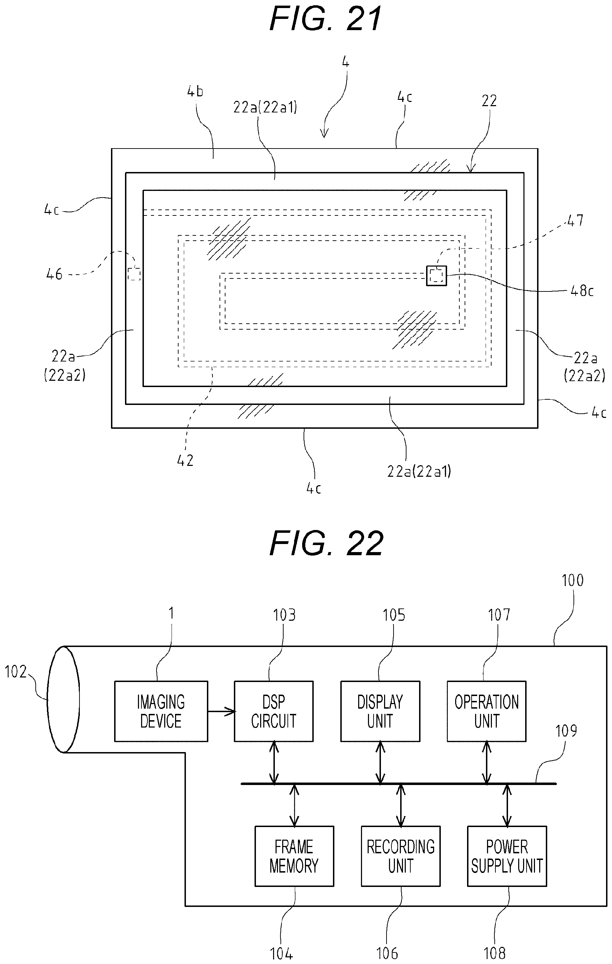

An application example of the imaging device according to the above-described embodiment to an electronic device will be described with reference to Fig. 22. Note that, here, an application example of the imaging device 1 according to the first embodiment will be described.

The imaging device 1 can be applied to all electronic devices using an imaging element in an image capturing unit (photoelectric conversion unit), such as a camera device such as a digital still camera or a video camera, a mobile terminal device having an imaging function, and a copying machine using an imaging element in an image reading unit. The imaging element may in the form that is formed as one chip, or may be in the form of a module having an imaging function in which an imaging unit and a signal processing unit or an optical system are packaged together.

As illustrated in Fig. 22, a camera device 100 as an electronic device includes an optical unit 102, an imaging device 1, a digital signal processor (DSP) circuit 103 which is a camera signal processing circuit, a frame memory 104, a display unit 105, a recording unit 106, an operation unit 107, and a power supply unit 108. The DSP circuit 103, the frame memory 104, the display unit 105, the recording unit 106, the operation unit 107, and the power supply unit 108 are appropriately connected via a connection line 109 such as a bus line.

The optical unit 102 includes a plurality of lenses, and captures incident light (image light) from a subject to form an image on an imaging surface of the imaging device 1. The imaging device 1 converts the light amount of the incident light from which an image is formed on the imaging surface by the optical unit 102 into an electrical signal in units of pixels and outputs the electrical signal as a pixel signal.

The display unit 105 includes, for example, a panel type display device such as a liquid crystal panel or an organic electro luminescence (EL) panel, and displays a moving image or a still image captured by the imaging device 1. The recording unit 106 records the moving image or the still image captured by the imaging device 1 on a recording medium such as a hard disk or a semiconductor memory.

The operation unit 107 issues operation commands for various functions of the camera device 100 under operation by the user. The power supply unit 108 appropriately supplies various power sources to be operation power sources of the DSP circuit 103, the frame memory 104, the display unit 105, the recording unit 106, and the operation unit 107 to these supply targets.

According to the camera device 100 as described above, in the imaging device 1, the image sensor 3 can be downsized by the configuration including the support portion 5 including the solder layer portion 20, and the package structure can be downsized. As the package structure is downsized, the camera device 100 can be downsized.

The description of the above-described embodiments is an example of the present technology, and the present technology is not limited to the above-described embodiments. For this reason, it is a matter of course that various modifications can be made according to the design and the like without departing from the technical idea according to the present disclosure even in a case other than the above-described embodiments. Furthermore, the effects described in the present disclosure are merely examples and are not limited, and other effects may be provided. Furthermore, the configurations of the above-described embodiments and the configurations of the modifications can be appropriately combined.

In the embodiment described above, the solder layer portion 20 constituting the support portion 5 is connected to the back surface 4b of the glass 4 via the glass-side connection layer portion 22, but the solder layer portion 20 may be a portion extending from the back surface 4b side to the side surface 4c side of the glass 4 and including a portion connected to the side surface 4c of the glass 4. In this case, for example, a connection layer portion similar to the glass-side connection layer portion 22 is formed on the side surface 4c of the glass 4, and the solder layer portion 20 is formed so as to cover the side surface 4c of the glass 4 with a part thereof.

Furthermore, in the above-described embodiment, in the manufacturing method of the imaging device 1, the solder portion 20X to be the solder layer portion 20 of the support portion 5 is provided with respect to the glass-side connection layer portion 22. In this regard, the solder portion 20X may be provided for the element-side connection layer portion 21 in the step of preparing the image sensor 3.

Note that the present technology can also employ the following configurations.

(1) An imaging device, including:

a substrate;
an imaging element mounted on the substrate and having a side opposite to a side of the substrate as a light receiving surface side;
a transparent member provided on the light receiving surface side of the imaging element at a predetermined interval with respect to the imaging element;
a support portion that is interposed between the imaging element and the transparent member and forms a cavity that is a sealed space between the imaging element and the transparent member; and
a connecting member that electrically connects the substrate and the imaging element, in which the support portion includes a solder layer portion formed by solder.

(2) The imaging device according to (1) above, further including
a covering resin portion that is provided around the imaging element on the substrate and covers the connecting member and connecting portions of the connecting member with respect to each of the substrate and the imaging element.

(3) The imaging device according to (1) or (2) above, in which
the transparent member has an outer dimension in plan view smaller than the outer dimension of the imaging element, and is provided within a range of an outer shape of the imaging element in plan view.

(4) The imaging device according to any one of (1) to (3) above, in which
the support portion includes a metal layer portion formed by copper or an alloy containing copper on at least one of a side of the imaging element or a side of the transparent member of the solder layer portion.

(5) The imaging device according to any one of (1) to (4) above, in which

the support portion includes
a first connection layer portion that is a connecting portion with respect to the imaging element, and a second connection layer portion that is a connecting portion with respect to the transparent member, and
an edge end on an inside of the second connection layer portion with respect to the cavity is positioned closer to the inside than an edge end on the inside of the first connection layer portion.

(6) The imaging device according to any one of (1) to (5) above, further including
a fine wiring portion provided on a surface of the transparent member on a side of the cavity and connected to a GND potential of the imaging element via the support portion.

(7) The imaging device according to any one of (1) to (5) above, further including
a heat-generating fine wiring portion that is provided on a surface of the transparent member on a side opposite to a side of the cavity, is electrically connected to the support portion, and generates heat by receiving supply of a current from the imaging element.

(8) The imaging device according to any one of (1) to (7) above, in which
nitrogen gas is sealed in the cavity.

(9) The imaging device according to any one of (1) to (7) above, in which
an inside of the cavity is in a vacuum state.

(10) An electronic device including an imaging device, in which

the imaging device includes
a substrate,
an imaging element mounted on the substrate and having a side opposite to a side of the substrate as a light receiving surface side,
a transparent member provided on the light receiving surface side of the imaging element at a predetermined interval with respect to the imaging element,
a support portion that is interposed between the imaging element and the transparent member and forms a cavity that is a sealed space between the imaging element and the transparent member, and
a connecting member that electrically connects the substrate and the imaging element, and
the support portion includes a solder layer portion formed by solder.

(11) A manufacturing method of an imaging device, the manufacturing method including the steps of:

preparing a substrate;
preparing an imaging element in which a first connection layer portion is formed on a light receiving surface side as an imaging element to be mounted on the substrate;
preparing, as a transparent member to be mounted on the imaging element, a transparent member on which a solder portion is formed via a second connection layer portion having a shape corresponding to the first connection layer portion on one side;
mounting the imaging element on the substrate;
providing a connecting member that electrically connects the substrate and the imaging element; and
placing the transparent member on the imaging element in such a manner that the solder portion is positioned on the first connection layer portion, melting the solder portion, and forming a support portion that is interposed between the imaging element and the transparent member and forms a cavity that is a sealed space between the imaging element and the transparent member.

(12) The manufacturing method of the imaging device according to (11) above, further including a step of forming a covering resin portion around the imaging element on the substrate so as to cover the connecting member and connecting portions of the connecting member with respect to each of the substrate and the imaging element after the step of forming the support portion.

(13) The manufacturing method of the imaging device according to (11) or (12) above, in which

the step of preparing the transparent member includes
a step of forming, on a surface of the transparent member on a side of the cavity, a fine wiring portion connected to a GND potential of the imaging element via the support portion.

(14) The manufacturing method of the imaging device according to (11) or (12) above, in which

the step of preparing the transparent member includes
a step of forming, on a surface of the transparent member on a side opposite to a side of the cavity, a heat-generating fine wiring portion that is electrically connected to the support portion and generates heat by receiving supply of a current from the imaging element.

(15) The manufacturing method of the imaging device according to any one of (11) to (14) above, in which
in the step of forming the support portion, nitrogen gas is sealed in the cavity.
(16) The manufacturing method of the imaging device according to any one of (11) to (14) above, in which
in the step of forming the support portion, an inside of the cavity is evacuated.

REFERENCE SIGNS LIST

| 1, 1A, 1B | Imaging device |
|---|---|
| 2 | Substrate |
| 3 | Image sensor (imaging element) |
| 3a | Front surface |
| 3c | Pixel unit |
| 4 | Glass (transparent member) |
| 4a | Front surface |
| 4b | Back surface |
| 5 | Support portion |
| 6 | Bonding wire (connecting member) |
| 7 | Cavity |
| 15 | Covering resin portion |
| 20 | Solder layer portion |
| 20X | Solder portion |
| 21 | Element-side connection layer portion |
| 22 | Glass-side connection layer portion |
| 27 | Copper layer portion (metal layer portion) |
| 30 | Fine wiring portion |
| 40 | Heat-generating fine wiring portion |
| 46 | First through-wiring portion |
| 47 | Second through-wiring portion |
| 48 | Interposed conductive portion |
| 100 | Camera device (electronic device) |

**Claims**

1. An imaging device, comprising:

a substrate;
an imaging element mounted on the substrate and having a side opposite to a side of the substrate as a light receiving surface side;
a transparent member provided on the light receiving surface side of the imaging element at a predetermined interval with respect to the imaging element;
a support portion that is interposed between the imaging element and the transparent member and forms a cavity that is a sealed space between the imaging element and the transparent member; and

a connecting member that electrically connects the substrate and the imaging element, wherein the support portion includes a solder layer portion formed by solder.

2. The imaging device according to claim 1, further comprising

a covering resin portion that is provided around the imaging element on the substrate and covers the connecting member and connecting portions of the connecting member with respect to each of the substrate and the imaging element.

3. The imaging device according to claim 1, wherein the transparent member has an outer dimension in plan view smaller than the outer dimension of the imaging element, and is provided within a range of an outer shape of the imaging element in plan view.

4. The imaging device according to claim 1, wherein the support portion includes a metal layer portion formed by copper or an alloy containing copper on at least one of a side of the imaging element or a side of the transparent member of the solder layer portion.

5. The imaging device according to claim 1, wherein

the support portion includes

a first connection layer portion that is a connecting portion with respect to the imaging element, and a second connection layer portion that is a connecting portion with respect to the transparent member, and

an edge end on an inside of the second connection layer portion with respect to the cavity is positioned closer to the inside than an edge end on the inside of the first connection layer portion.

6. The imaging device according to claim 1, further comprising

a fine wiring portion provided on a surface of the transparent member on a side of the cavity and connected to a GND potential of the imaging element via the support portion.

7. The imaging device according to claim 1, further comprising

a heat-generating fine wiring portion that is provided on a surface of the transparent member on a side opposite to a side of the cavity, is electrically connected to the support portion, and generates heat by receiving supply of a current from the imaging element.

8. The imaging device according to claim 1, wherein nitrogen gas is sealed in the cavity.

9. The imaging device according to claim 1, wherein an inside of the cavity is in a vacuum state.

10. An electronic device comprising an imaging device, wherein

the imaging device includes
a substrate,
an imaging element mounted on the substrate and having a side opposite to a side of the substrate as a light receiving surface side,
a transparent member provided on the light receiving surface side of the imaging element at a predetermined interval with respect to the imaging element,
a support portion that is interposed between the imaging element and the transparent member and forms a cavity that is a sealed space between the imaging element and the transparent member, and
a connecting member that electrically connects the substrate and the imaging element, and
the support portion includes a solder layer portion formed by solder.

11. A manufacturing method of an imaging device, the manufacturing method comprising the steps of:

preparing a substrate;
preparing an imaging element in which a first connection layer portion is formed on a light receiving surface side as an imaging element to be mounted on the substrate;
preparing, as a transparent member to be mounted on the imaging element, a transparent member on which a solder portion is formed via a second connection layer portion having a shape corresponding to the first connection layer portion on one side;
mounting the imaging element on the substrate;
providing a connecting member that electrically connects the substrate and the imaging element; and
placing the transparent member on the imaging element in such a manner that the solder portion is positioned on the first connection layer portion, melting the solder portion, and forming a support portion that is interposed between the imaging element and the transparent member and forms a cavity that is a sealed space between the imaging element and the transparent member.

12. The manufacturing method of the imaging device according to claim 11, further comprising
a step of forming a covering resin portion around the imaging element on the substrate so as to cover the connecting member and connecting portions of the connecting member with respect to each of the substrate and the imaging element after the step of forming the support portion.

13. The manufacturing method of the imaging device according to claim 11, wherein

the step of preparing the transparent member includes
a step of forming, on a surface of the transparent member on a side of the cavity, a fine wiring portion connected to a GND potential of the imaging element via the support portion.

14. The manufacturing method of the imaging device according to claim 11, wherein

the step of preparing the transparent member includes
a step of forming, on a surface of the transparent member on a side opposite to a side of the cavity, a heat-generating fine wiring portion that is electrically connected to the support portion and generates heat by receiving supply of a current from the imaging element.

15. The manufacturing method of the imaging device according to claim 11, wherein
in the step of forming the support portion, nitrogen gas is sealed in the cavity.

16. The manufacturing method of the imaging device according to claim 11, wherein
in the step of forming the support portion, an inside of the cavity is evacuated.

# FIG. 1

# FIG. 2

## FIG. 3

## FIG. 4

## FIG. 5

# FIG. 6

## A

## B

# FIG. 7

# FIG. 8

# FIG. 9

# FIG. 10

# FIG. 11

# FIG. 12

## FIG. 13

## FIG. 14

# FIG. 15

# FIG. 16

# FIG. 17

# FIG. 18

# FIG. 19

# FIG. 20

# FIG. 21

# FIG. 22

## INTERNATIONAL SEARCH REPORT

| International application No. |
|---|
| **PCT/JP2021/033083** |

### A. CLASSIFICATION OF SUBJECT MATTER

*H01L 23/02*(2006.01)i; *H01L 23/20*(2006.01)i; *H01L 27/146*(2006.01)i; *H04N 5/369*(2011.01)i
FI: H01L27/146 D; H04N5/369; H01L23/02 F; H01L23/02 C; H01L23/20

According to International Patent Classification (IPC) or to both national classification and IPC

### B. FIELDS SEARCHED

Minimum documentation searched (classification system followed by classification symbols)

H01L23/02; H01L23/20; H01L27/146; H04N5/369

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 2014-75480 A (SEIKO INSTRUMENTS INC.) 24 April 2014 (2014-04-24) paragraphs [0029]-[0055], fig. 1-6 | 1-2, 4, 10-12 |
| Y | | 3-9, 13-16 |
| Y | JP 11-326037 A (MITSUBISHI ELECTRIC CORP.) 26 November 1999 (1999-11-26) paragraphs [0015]-[0023], fig. 1-7 | 1-16 |
| Y | JP 10-115556 A (MITSUBISHI ELECTRIC CORP.) 06 May 1998 (1998-05-06) paragraphs [0019]-[0026], fig. 1-8 | 1-16 |
| Y | JP 2010-287619 A (CANON INC.) 24 December 2010 (2010-12-24) paragraphs [0014]-[0037], fig. 1-3, 8 | 1-16 |
| Y | JP 2012-174738 A (CANON INC.) 10 September 2012 (2012-09-10) paragraphs [0008]-[0033], fig. 1-7 | 1-16 |
| Y | JP 2006-332680 A (AVAGO TECHNOLOGIES GENERAL IP (SINGAPORE) PRIVATE LTD.) 07 December 2006 (2006-12-07) paragraphs [0005]-[0033], fig. 1-10 | 1-16 |

☑ Further documents are listed in the continuation of Box C.     ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **16 November 2021** | **22 November 2021** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

## INTERNATIONAL SEARCH REPORT

International application No.

**PCT/JP2021/033083**

### C. DOCUMENTS CONSIDERED TO BE RELEVANT

| Category* | Citation of document, with indication, where appropriate, of the relevant passages | Relevant to claim No. |
|---|---|---|
| Y | JP 2011-142270 A (TOSHIBA CORP.) 21 July 2011 (2011-07-21)<br>paragraphs [0014]-[0022], fig. 1-3 | 6, 13 |
| Y | JP 2011-66560 A (SHARP CORP.) 31 March 2011 (2011-03-31)<br>paragraphs [0038]-[0061], fig. 1-10 | 7, 14 |
| Y | JP 2007-299929 A (MATSUSHITA ELECTRIC INDUSTRIAL CO., LTD.) 15 November 2007 (2007-11-15)<br>paragraphs [0066]-[0076], fig. 10 | 7, 14 |
| Y | JP 2007-158751 A (HITACHI MAXELL LTD.) 21 June 2007 (2007-06-21)<br>paragraphs [0032]-[0074], fig. 1-9 | 8-9, 15-16 |
| Y | JP 2013-24745 A (PANASONIC CORP.) 04 February 2013 (2013-02-04)<br>paragraphs [0017]-[0102], fig. 1-20 | 8, 15 |
| A | JP 2006-10405 A (MITSUBISHI ELECTRIC CORP.) 12 January 2006 (2006-01-12)<br>entire text, all drawings | 1-16 |
| A | US 2009/0032925 A1 (ENGLAND, Luke G.) 05 February 2009 (2009-02-05)<br>entire text, all drawings | 1-16 |
| A | JP 2009-302102 A (SONY CORP.) 24 December 2009 (2009-12-24)<br>entire text, all drawings | 1-16 |
| A | JP 2003-110040 A (KYOCERA CORP.) 11 April 2003 (2003-04-11)<br>entire text, all drawings | 1-16 |

Form PCT/ISA/210 (second sheet) (January 2015)

**INTERNATIONAL SEARCH REPORT**
Information on patent family members

International application No.

**PCT/JP2021/033083**

| Patent document cited in search report | | | Publication date (day/month/year) | Patent family member(s) | | | Publication date (day/month/year) |
|---|---|---|---|---|---|---|---|
| JP | 2014-75480 | A | 24 April 2014 | (Family: none) | | | |
| JP | 11-326037 | A | 26 November 1999 | (Family: none) | | | |
| JP | 10-115556 | A | 06 May 1998 | US<br>column 4, line 24 to column 6,<br>line 55, fig. 1-8<br>GB | 5914488<br><br><br>2310952 | A<br><br><br>A | |
| JP | 2010-287619 | A | 24 December 2010 | US<br>paragraphs [0021]-[0047], fig.<br>1A-3B, 8A-8B<br>CN | 2010/0309354<br><br><br>101924115 | A1<br><br><br>A | |
| JP | 2012-174738 | A | 10 September 2012 | US<br>paragraphs [0016]-[0041], fig.<br>1A-7<br>CN | 2012/0212637<br><br><br>102646647 | A1<br><br><br>A | |
| JP | 2006-332680 | A | 07 December 2006 | US<br>paragraphs [0017]-[0045], fig.<br>1A-10<br>DE<br>CN<br>TW | 2006/0268144<br><br><br>102006023879<br>1905144<br>200703531 | A1<br><br><br>A1<br>A<br>A | |
| JP | 2011-142270 | A | 21 July 2011 | (Family: none) | | | |
| JP | 2011-66560 | A | 31 March 2011 | (Family: none) | | | |
| JP | 2007-299929 | A | 15 November 2007 | US<br>paragraphs [0083]-[0093], fig.<br>10<br>CN | 2007/0252227<br><br><br>101064329 | A1<br><br><br>A | |
| JP | 2007-158751 | A | 21 June 2007 | CN<br>KR | 1979243<br>10-2007-0059998 | A<br>A | |
| JP | 2013-24745 | A | 04 February 2013 | (Family: none) | | | |
| JP | 2006-10405 | A | 12 January 2006 | (Family: none) | | | |
| US | 2009/0032925 | A1 | 05 February 2009 | (Family: none) | | | |
| JP | 2009-302102 | A | 24 December 2009 | (Family: none) | | | |
| JP | 2003-110040 | A | 11 April 2003 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002016194 A

- JP 2003163342 A